(19) Europäisches Patentamt
European Patent Office
Office européen des brevets

(11) EP 2 048 776 A1

(12) EUROPEAN PATENT APPLICATION
published in accordance with Art. 153(4) EPC

(43) Date of publication:
15.04.2009 Bulletin 2009/16

(51) Int Cl.:
H03D 7/18 (2006.01)          H04B 1/26 (2006.01)

(21) Application number: 07768291.2

(22) Date of filing: 06.07.2007

(86) International application number:
PCT/JP2007/063559

(87) International publication number:
WO 2008/013041 (31.01.2008 Gazette 2008/05)

(84) Designated Contracting States:
AT BE BG CH CY CZ DE DK EE ES FI FR GB GR
HU IE IS IT LI LT LU LV MC MT NL PL PT RO SE
SI SK TR
Designated Extension States:
AL BA HR MK RS

(30) Priority: 27.07.2006 JP 2006204360

(71) Applicant: Panasonic Corporation
Kadoma-shi
Osaka 571-8501 (JP)

(72) Inventors:
• ASAYAMA, Sanae
2-1-61 Shiromi
Chuo-ku
Osaka-shi
Osaka 540-6207 (JP)
• TERAO, Atsuhito
2-1-61 Shiromi
Chuo-ku
Osaka-shi
Osaka 540-6207 (JP)

(74) Representative: Pautex Schneider, Nicole
Véronique et al
Novagraaf International SA
25, avenue du Pailly
1220 Les Avanchets - Geneva (CH)

(54) MIXING DEVICE AND HIGH-FREQUENCY RECEIVER USING THE SAME

(57) A mixing device includes a mixing circuit and a ring oscillation circuit. The mixing circuit includes "M" mixers connected to the input terminal of the mixing device at one input. The ring oscillation circuit includes $(2 \times M)$ inverters connected in series in a ring shape. The other input of the K-th mixer where "K" is a natural number of 1 to "M" balance-inputs an oscillation signal which is phase-shifted by $(-K\pi/M)$ radian and outputted from the K-th inverter and an oscillation signal which is phase-shifted by $(-(M + K)\pi/M)$ radian and outputted from the (M + K)th inverter. Between the output of the K-th mixer and the output terminal is provided a phase shifter having a phase shift amount of $(-2\pi + K\pi/M)$ radian.

FIG. 6

**Description**

**TECHNICAL FIELD**

The present invention relates to a mixing device used to receive broadcast and communication signals and to a radio-frequency receiver using the mixing device.

**BACKGROUND ART**

Conventional mixing devices can suppress image interference signals and interference signals having a frequency higher or lower by the intermediate frequency (hereinafter, IF) than the frequency three times the fundamental frequency of the oscillator.

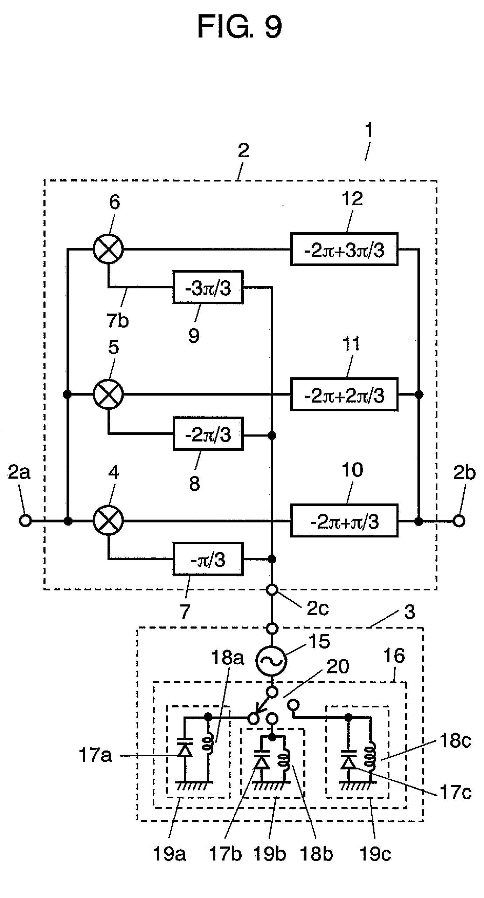

As shown in Fig. 9, mixing device 1 includes mixing circuit 2 and oscillation circuit 3. Mixing circuit 2 has input terminal 2a, output terminal 2b, and input terminal 2c for receiving an oscillation signal from oscillation circuit 3.

Mixing circuit 2 includes mixers 4, 5, and 6 each connected to input terminal 2a at one input thereof. Mixing circuit 2 further includes phase shifters 7, 8, and 9. Phase shifter 7 is connected between the other input of mixer 4 and input terminal 2c so as to shift the phase by $(-\pi/3)$ radian. Phase shifter 8 is connected between the other input of mixer 5 and input terminal 2c so as to shift the phase by $(-2\pi/3)$ radian. Phase shifter 9 is connected between the other input of mixer 6 and input terminal 2c so as to shift the phase by $(-3\pi/3)$ radian. Mixing circuit 2 further includes other shifters 10, 11, and 12. Phase shifter 10 is connected between the output of mixer 4 and output terminal 2b so as to shift the phase by $(-2\pi + \pi/3)$ radian. Phase shifter 11 is connected between the output of mixer 5 and output terminal 2b so as to shift the phase by $(-2\pi + 2\pi/3)$ radian. Phase shifter 12 is connected between the output of mixer 6 and output terminal 2b so as to shift the phase by $(-2\pi + 3\pi/3)$ radian.

Oscillation circuit 3, on the other hand, includes oscillator 15 and tuning circuit 16 connected thereto. Oscillator 15 is connected to input terminal at its output 2c. Tuning circuit 16 includes parallel circuits 19a, 19b, and 19c, and electronic switch 20 for selecting one of parallel circuits 19a, 19b, and 19c. Parallel circuit 19a includes tuning capacitor 17a and tuning inductor 18a connected parallel to each other. Parallel circuit 19b includes tuning capacitor 17b and tuning inductor 18b connected parallel to each other. Parallel circuit 19c includes tuning capacitor 17c and tuning inductor 18c connected parallel to each other.

The following is a description of the operation of mixing device 1 thus structured. In mixing device 1, electronic switch 20 selects one of parallel circuits 19a, 19b, and 19c so as to determine the oscillation frequency. Phase shifters 7, 8, and 9 phase-shift the oscillation signal of oscillation circuit 3 by $(-\pi/3)$ radian, $(-2\pi/3)$ radian, and $(-3\pi/3)$ radian, respectively, and then supply the phase-shifted signals to the other inputs of mixers 4, 5, and mixer 6, respectively.

Phase shifters 10, 11, and 12 phase-shift the output signals of mixers 4, 5, and 6 by $(-2\pi + \pi/3)$ radian, $(-2\pi + 2\pi/3)$ radian, and $(-2\pi + 3\pi/3)$ radian, respectively. Then, output terminal 2b outputs a signal obtained by combining these phase-shifted signals.

This process phase-cancels and suppresses an image interference signal, interference signals having a frequency higher or lower by the IF than the frequency three times the fundamental frequency of oscillation circuit 3, and interference signals having a frequency lower by the IF than the frequency five times the fundamental frequency of oscillation circuit 3.

One example of mixing device 1 is shown in Patent Document 1. In this conventional structure, receiving the frequencies in the UHF band (470 MHz to 770 MHz) requires that oscillation circuit 3 can change the frequency range and that phase shifters 7, 8, and 9 have high phase accuracy in the broadband frequency range.

To meet this requirement, oscillation circuit 3 includes parallel circuits 19a, 19b, and 19c and tuning circuit 16 which selects one of them so as to cover the variation range of the oscillation frequency. Thus, when mounted on a mobile receiver, which is operated at low voltage, a plurality of parallel circuits are required to cover the broadband oscillation frequency range. The problem, however, is that inductors 18a, 18b, and 18c of parallel circuits 19a, 19b, and 19c occupy a particularly large space as integrated circuit chips.

It is possible to use a ring oscillation circuit instead of oscillation circuit 3; however, conventional ring oscillation circuits simply generate orthogonal signals different in phase by 90 degrees from each other, and use these signals for direct conversion (see, for example, Non-Patent Document 1).

Furthermore, phase shifters 7, 8, and 9 of mixing circuit 2 use flip-flops to meet the demand for a highly accurate phase shift amount in the broadband frequency range.

As described hereinbefore, when a mixing device thus formed of oscillation circuit 3 and mixing circuit 2 is implemented as an integrated circuit, oscillation circuit 3 requires a plurality of parallel circuits 19a, 19b, and 19c and selector switch 20, while in mixing circuit 2, phase shifters 7, 8, and 9 increase in chip size due to the flip-flops. This prevents the formation of a compact radio-frequency receiver.

Patent Document 1: Japanese Patent Unexamined Publication No. 2004-179841
Non-Patent Document 1: Akihiko Yoneya (Nagoya Institute of Technology), Papers of Technical Meeting on Electronic Circuits, ECT-03-43, IEE Japan, pp. 1-4, March 14, 2003

## SUMMARY OF THE INVENTION

The mixing device of the present invention includes an input terminal for receiving a radio frequency signal, and a mixing circuit having a first mixer to an M-th mixer connected to each other where "M" is a natural number of not less than 3, the mixing circuit being connected to the input terminal at one input so as to receive the radio frequency signal received by the input terminal. The mixing device further includes a ring oscillation circuit connected to the other inputs of the first to M-th mixers so as to supply an output signal thereto, and an output terminal for receiving the outputs of the first to M-th mixers. The mixing device further includes a K-th phase shifter where "K" is a natural number of 1 to "M", the K-th phase shifter being between the output of the K-th mixer and the output terminal, and having a phase shift amount of $(-2\pi + K\pi/M)$ radian.

The ring oscillation circuit includes a first ring oscillating part having at least a first inverter to a $(2 \times M)$th inverter or at least a first differential amplifier to a $(2 \times M)$th differential amplifier.

When the ring oscillation circuit includes the first to $(2 \times M)$th inverters, the other input of the K-th mixer balance-inputs an oscillation signal phase-shifted by $(-K\pi/M)$ radian which outputted from the K-th inverter and an oscillation signal phase-shifted by $(-(M + K)\pi/M)$ radian which outputted from the $(M + K)$th inverter.

When the ring oscillation circuit includes the first to $(2 \times M)$th differential amplifiers, the other input of the K-th mixer balance-inputs an oscillation signal phase-shifted by $(-K\pi/M)$ radian which outputted from the K-th differential amplifier and an oscillation signal phase-shifted by $(-(M + K)\pi/M)$ radian which outputted from the $(M + K)$th differential amplifier.

This structure enables the mixing device of the present invention to phase-cancel and suppress an image interference signal and all interference signals having a frequency higher or lower by the IF than the frequency three to $(2M - 3)$ times the fundamental frequency of the oscillator.

## BRIEF DESCRIPTION OF THE DRAWINGS

Fig. 1 is a block diagram of a mixing device according to a first embodiment of the present invention.
Fig. 2 is a diagram of the phases of desired signals and image interference signals of the mixing device.
Fig. 3 is a diagram of the phases of interference signals related to the frequency three times the fundamental frequency of a ring oscillation circuit of the mixing device according to the first embodiment of the present invention.
Fig. 4 is a relation diagram between broadcast channels available in North America and the interference signals related to the higher order harmonic frequencies of an oscillator in the mixing device according to the first embodiment of the present invention.
Fig. 5 is a block diagram of a mixing device according to a second embodiment of the present invention.
Fig. 6 is a block diagram of a mixing device according to a third embodiment of the present invention.
Fig. 7 is a block diagram of a mixing device according to a fourth embodiment of the present invention.
Fig. 8 is a block diagram of a radio-frequency receiver according to a fifth embodiment of the present invention.
Fig. 9 is a block diagram of a conventional mixing device.

## REFERENCE MARKS IN THE DRAWINGS

| | |
|---|---|
| 31, 331, 431, 531, 601 | mixing device |
| 32, 332 | mixing circuit |
| 32a, 61, 62, 63, 64, 65, 66, 332a, 602a | input terminal |
| 32b, 35, 36, 37, 38, 65, 66, 332b, 602b | output terminal |
| 33, 333, 433, 533 | ring oscillation circuit |
| 34, 334, 434, 534 | power supply terminal |
| 40 | package |
| 51, 52, 53, 54, 55, 56, 351, 351, 352, 353, 354, 355, 356, 357, 358, 359, 360 | differential amplifier |
| 71, 72, 73, 371, 372, 373, 374, 375 | mixer |

| 74, 75, 76, 391, 392, 393, 394, 395 | phase shifter |
| 433a | first ring oscillating part |
| 433b | second ring oscillating part |
| 451, 452, 453, 454, 455, 456, 457, 458, 459, 460, 461, 462, 463, 464, 465, 466, 467, 468, 469, 470 | inverter |
| 533a | third ring oscillating part |
| 533b | fourth ring oscillating part |
| 533c | oscillation control unit |
| 602 | radio-frequency receiver |
| 603 | filter |

## DETAILED DESCRIPTION OF PREFERRED EMBODIMENTS

Embodiments of the present invention are described as follows with reference to drawings.

## FIRST EMBODIMENT

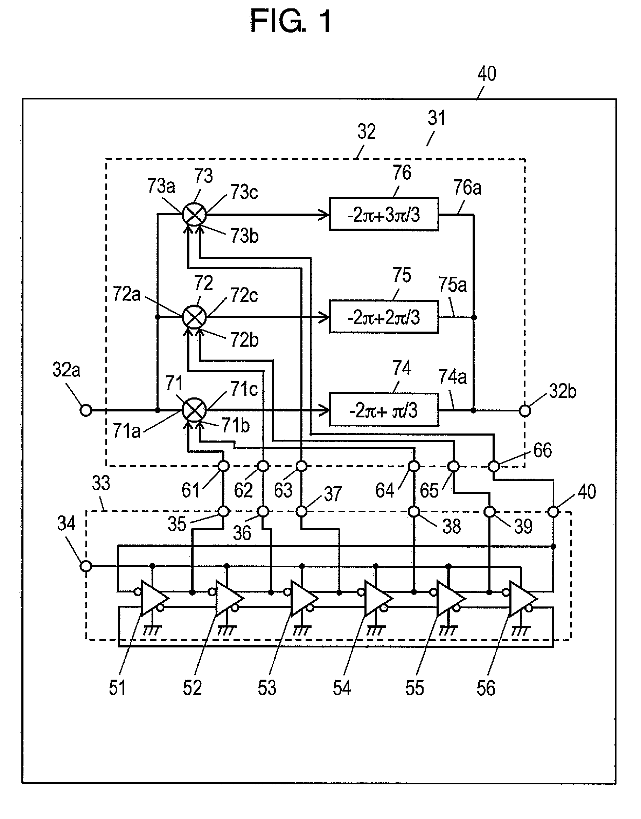

Fig. 1 is a block diagram of mixing device 31 according to a first embodiment of the present invention. In Fig. 1, mixing device 31 of the present embodiment includes mixing circuit 32 and ring oscillation circuit 33. Mixing circuit 32 has input terminal 32a and output terminal 32b. Ring oscillation circuit 33 supplies an oscillation signal to mixing circuit 32.

First, the structure of ring oscillation circuit 33 is described as follows. Ring oscillation circuit 33 includes differential amplifiers 51 to 56 connected in series in this order so as to invert and output input signals. Differential amplifiers 51 to 56 are each formed of two amplifiers connected differentially to each other.

The output of differential amplifier 51 is connected to the input of differential amplifier 52. The output of differential amplifier 52 is connected to the input of differential amplifier 53. The output of differential amplifier 53 is connected to the input of differential amplifier 54. The output of differential amplifier 54 is connected to the input of differential amplifier 55. The output of differential amplifier 55 is connected to the input of differential amplifier 56. The output of differential amplifier 56 is connected to the input of differential amplifier 51.

The power inputs of differential amplifiers 51 to 56 are all connected to power supply terminal 34 of ring oscillation circuit 33.

The outputs of differential amplifiers 51 to 56 are connected to output terminals 35 to 40, respectively, of ring oscillation circuit 33.

The oscillation operation of ring oscillation circuit 33 thus structured is described as follows. In ring oscillation circuit 33, the input signal of differential amplifier 51 is inverted and amplified by differential amplifiers 51 to 56 and returns to the input of differential amplifier 51. As a result, the degree of amplification of the loop formed by differential amplifiers 51 to 56 is 1 or more and the oscillation frequency is the frequency at which the phase delay is $(-2\pi)$ radian between the input signal of differential amplifier 51 and the output signal of differential amplifier 56.

The phase delay is determined as follows. The output currents of differential amplifiers 51 to 56 charge or discharge the input capacitors and input resistors of the differential amplifiers in the subsequent stages and the mixers connected to the outputs of differential amplifiers 51 to 56. The time required for the charge-discharge causes the phase delay.

Consequently, the output signal of differential amplifier 51 is delayed in phase. The output signal of differential amplifier 52 is further delayed in phase. In the same manner, the output signals of differential amplifiers 53 to 56 are sequentially delayed in phase.

The output currents of differential amplifiers 51 to 56 can be controlled by the value of the voltage applied to power supply terminal 34 so as to change the oscillation frequency of ring oscillation circuit 33. For example, when the voltage to be applied to power supply terminal 34 is controlled to be 0.5 to 3.0V, the oscillation frequency of ring oscillation circuit 33 can be changed to 450 to 1000 MHz, which are used to receive the UHF band.

The phases of the outputs of differential amplifiers 51 to 56 are described as follows . Differential amplifiers 51 to 56 may be formed of six inverters having common properties. Therefore, the phase difference between the input and output of each inverter can be $(-\pi/3)$ radian, which is obtained by dividing the phase delay between the input signal of differential amplifier 51 and the output signal of differential amplifier 56 by the number of the inverters. In other words, the phase difference of $(-\pi/3)$ radian is obtained by dividing $(-2\pi)$ radian by 6.

This means that the phase of the output signal is delayed by $(-\pi/3)$ radian from that of the input signal in each of differential amplifiers 51 to 56. As a result, the phases of the output signals of differential amplifiers 51 to 56 are delayed from that of the input signal of differential amplifier 51 by $(-\pi/3)$ radian, $(-2\pi/3)$ radian, $(-3\pi/3)$ radian, $(-4\pi/3)$ radian, $(-5\pi/3)$ radian, and $(-2\pi)$ radian, respectively,

These signals delayed in phase by (-π/3) radian, (-2π/3) radian, (-3π/3) radian, (-4π/3) radian, (-5π/3) radian, and (-2π) radian are outputted from output terminals 35 to 40, respectively.

The following is a description of the structure of mixing circuit 32 which receives an oscillation signal from ring oscillation circuit 33. Mixing circuit 32 has input terminal 32a for receiving a radio frequency signal; output terminal 32b for outputting an intermediate frequency signal; and input terminals 61 to 66 connected to output terminal 35 to 40, respectively, of ring oscillation circuit 33.

Mixing circuit 32 includes mixers 71, 72, and 73. The number of the mixers, "M", is 3 in the present embodiment, and is a natural number of 3 or more in the present invention. Mixer 71 is connected to input terminal 32a at one input 71a and to input terminals 61 and 64 at another input 71b. Mixer 72 is connected to input terminal 32a at one input 72a and to input terminals 62 and 65 at another input 72b. Mixer 73 is connected to input terminal 32a at one input 73a and to input terminals 63 and 66 at another input 73b.

Mixing circuit 32 further includes phase shifters 74, 75, and 76. Phase shifter 74 is connected between output 71c of mixer 71 and output terminal 32b and has a phase shift amount of (-2π + π/3) radian. Phase shifter 75 is connected between output 72c of mixer 72 and output terminal 32b and has a phase shift amount of (-2π + 2π/3) radian. Phase shifter 76 is connected between output 73c of mixer 73 and output terminal 32b and has a phase shift amount of (-2π + 3π/3) radian.

The operation of mixing device 31 thus structured is described using calculation formulas. For easier explanation, the magnitudes of the input signal to input terminal 32a; the fundamental output component of ring oscillation circuit 3; and the third harmonic components generated by mixers 71, 72, and 73 from the fundamental output component of ring oscillation circuit 33 are all 1. In addition, the gains of mixers 71, 72, and 73, and the gains of phase shifters 74, 75, and 76 are all 1.

The reason for this is that the signal from output terminal 32b is outputted by adding three signals or suppressing them, so that the phase is much more important than the magnitude.

More specifically, the following input signals have a magnitude of 1: a desired signal $V_d$; an image interference signal $V_i$; an interference signal having a frequency lower by the IF than the frequency three times the fundamental frequency of ring oscillation circuit 33 (hereinafter $V_{m1}$) ; and an interference signal having a frequency higher by the IF than the frequency three times the fundamental frequency of ring oscillation circuit 33 (hereinafter, $V_{m2}$).

In addition, the magnitudes of the third harmonic components $V_{L3}$ (71b), $V_{L3}$ (72b), and $V_{L3}$ (73b) are set to 1 for easier explanation. Actually, however, the third harmonic component $V_{L3}$ (71b) generated by mixer 71 from fundamental output component $V_{L1}$ (71b) which is the output signal of differential amplifier 51 is smaller than the fundamental output component $V_{L1}$ (71b). The third harmonic component $V_{L3}$ (72b) generated by mixer 72 from the fundamental output component $V_{L1}$ (72b) which is the output signal of differential amplifier 52 is smaller than the fundamental output component $V_{L1}$ (72b). The third harmonic component $V_{L3}$ (73b) generated by mixer 73 from the fundamental output component $V_{L1}$ (73b) which is the output signal of differential amplifier 53 is smaller than the fundamental output component $V_{L1}$ (73b).

The following is a description, with reference to calculation formulas, of the case where input terminal 32a receives the desired signal $V_d$ and the image interference signal $V_i$.

The desired signal $V_d$ is expressed by Mathematical Formula 1 below.

$$V_d = \sin(\omega_1 t - \theta_1), \qquad (1)$$

where $\omega_1$ is an angular frequency, t is time, and $\theta_1$ is a phase angle.

The image interference signal $V_i$ is expressed by Mathematical Formula 2 below.

$$V_i = \sin(\omega_3 t - \theta_3), \qquad (2)$$

where $\omega_3$ is an angular frequency and $\theta_3$ is a phase angle.

The fundamental output component $V_{L1}$ (71b), which is the output signal of differential amplifier 51 is expressed by Mathematical Formula 3 below.

$$V_{L1}(71b) = \sin(\omega_2 t - \theta_2 - \pi/3), \qquad (3)$$

where $\omega_2$ is an angular frequency and $\theta_2$ is a phase angle.

The fundamental output component $V_{L1}$ (72b), which is the output signal of differential amplifier 52 is expressed by Mathematical Formula 4 below.

$$V_{L1}(72b) = \sin(\omega_2 t - \theta_2 - 2\pi/3). \qquad (4)$$

The fundamental output component $V_{L1}$ (73b), which is the output signal of differential amplifier 53 is expressed by Mathematical Formula 5 below.

$$V_{L1}(73b) = \sin(\omega_2 t - \theta_2 - 3\pi/3). \qquad (5)$$

One input 71a of mixer 71 receives the desired signal $V_d$ and the image interference signal $V_i$, which are divided to three mixers 71 to 73. The other input 71b of mixer 71 receives the fundamental output component $V_{L1}$ (71b), which is the output signal of differential amplifier 51. Consequently, an IF signal $V_1$ (71c) expressed by Mathematical Formula 6 below is outputted to output 71c of mixer 71.

$$V_1(71c) = 1/3 \times (V_d + V_i) \times \sin(\omega_2 t - \theta_2 - \pi/3)$$
$$= 1/3 \times (1/2 \times \cos(\omega_2 t - \omega_1 t + \theta_1 - \theta_2 - \pi/3)$$
$$+ 1/2 \times \cos(\omega_3 t - \omega_2 t - \theta_3 + \theta_2 + \pi/3)). \qquad (6)$$

The IF signal $V_1$ (71c) is phase-shifted by $(-2\pi + \pi/3)$ radian by phase shifter 74. Consequently, an IF signal $V_1$ (74a) expressed by Mathematical Formula 7 below is outputted to output 74a of phase shifter 74.

$$V_1(74a) = 1/3 \times (1/2 \times \cos(\omega_2 t - \omega_1 t + \theta_1 - \theta_2)$$
$$+ 1/2 \times \cos(\omega_3 t - \omega_2 t - \theta_3 + \theta_2 + 2\pi/3)). \qquad (7)$$

Furthermore, one input 72a of mixer 72 receives the same signal as one input 71a of mixer 71. The other input 72b of mixer 72 receives the fundamental output component $V_{L1}$ (72b), which is the output signal of differential amplifier 52. Consequently, an IF signal $V_1$ (72c) expressed by Mathematical Formula 8 below is outputted to output 72c of mixer 72.

$$V_1(72c) = 1/3 \times (V_d + V_i) \times \sin(\omega_2 t - \theta_2 - 2\pi/3)$$
$$= 1/3 \times (1/2 \times \cos(\omega_2 t - \omega_1 t + \theta_1 - \theta_2 - 2\pi/3)$$
$$+ 1/2 \times \cos(\omega_3 t - \omega_2 t - \theta_3 + \theta_2 + 2\pi/3)). \qquad (8)$$

The IF signal $V_1$ (72c) is phase-shifted by $(-2\pi + 2\pi/3)$ radian by phase shifter 75. Consequently, an IF signal $V_1$ (75a) expressed by Mathematical Formula 9 below is outputted to output 75a of phase shifter 75.

$$V_1(75a) = 1/3 \times (1/2 \times \cos(\omega_2 t - \omega_1 t + \theta_1 - \theta_2)$$
$$+ 1/2 \times \cos(\omega_3 t - \omega_2 t - \theta_3 + \theta_2 - 2\pi/3)). \qquad (9)$$

Furthermore, one input 73a of mixer 73 receives the same signal as one input 71a of mixer 71. The other input 73b of mixer 73 receives the fundamental output component $V_{L1}$ (73b), which is the output signal of differential amplifier 53. Consequently, an IF signal $V_1$ (73c) expressed by Mathematical Formula 10 below is outputted to output 73c of mixer 73.

$$V_1(73c) = 1/3 \times (V_d + V_i) \times \sin(\omega_1 t - \theta_1 - 3\pi/3)$$
$$= 1/3 \times (1/2 \times \cos(\omega_2 t - \omega_1 t + \theta_1 - \theta_2 - 3\pi/3)$$
$$+ 1/2 \times \cos(\omega_3 t - \omega_2 t - \theta_3 + \theta_2 + 3\pi/3)). \qquad (10)$$

The IF signal $V_1$ (73c) is phase-shifted by $(-2\pi + 3\pi/3)$ radian by phase shifter 76. Consequently, an IF signal $V_1$ (76a) expressed by Mathematical Formula 11 below is outputted to output 76a of phase shifter 76.

$$V_1(76a) = 1/3 \times (1/2 \times \cos(\omega_2 t - \omega_1 t + \theta_1 - \theta_2)$$
$$+ 1/2 \times \cos(\omega_3 t - \omega_2 t - \theta_3 + \theta_2)). \qquad (11)$$

The IF signal $V_1$ (32b) outputted from output terminal 32b is a combination of three signals : the IF signal $V_1$ (74a), the IF signal $V_1$ (75a), and the IF signal $V_1$ (76a) as shown in Mathematical Formula 12 below.

$$V_1(32b) = V_1(74a) + V_1(75a) + V_1(76a)$$
$$= 1/2 \times \cos(\omega_2 t - \omega_1 t + \theta_1 - \theta_2). \qquad (12)$$

The three signals are combined because the first terms of the IF signals $V_1$ (74a), $V_1$ (75a), and $V_1$ (76a), which are the IF components of the desired signal $V_d$, are in-phase with each other as apparent from Mathematical Formula 12. As a result, the IF signal $V_1$ (32b), which is a desired signal, is outputted from output terminal 32b.

On the other hand, the second terms of the IF signals $V_1$ (74a), $V_1$ (75a), and $V_1$ (76a), which are image interference signals $V_i$, are phase-cancelled with each other. As a result, the image interference signals $V_i$ are not outputted from output terminal 32b.

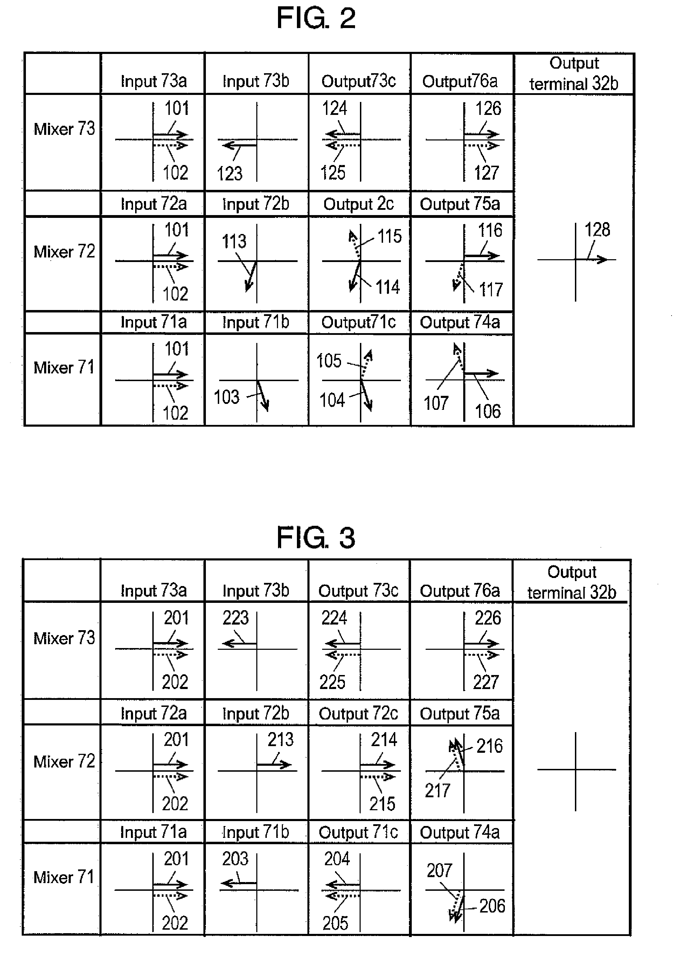

The changes in the signal phase are described as follows based on these calculation formulas with reference to Fig. 2. For easier explanation, assume that the phases $\theta_2$, $\theta_1$, and $\theta_3$ of the fundamental output component, the desired signals, and the image interference signals of differential amplifier 51 are all 0 radian.

Fig. 2 is a diagram of the phases of desired signals and image interference signals of the mixing device according to the first embodiment of the present invention. The diagram shows the phases of the desired signals and the image interference signals at each point of mixers 71, 72, and 73 and does not show their magnitudes. The desired signals are shown in solid lines, and the image interference signals are shown in dotted lines.

The following is a description, with reference to Fig. 2, of how the desired signals are passed and the image interference signals are cancelled.

First, one input 71a of mixer 71 receives desired signal 101 and image interference signal 102 each having a phase of 0 radian. The other input 71b of mixer 71 receives oscillation signal 103 having a phase of $(-\pi/3)$ radian.

From Mathematical Formula 6 above, output 71c of mixer 71 outputs desired signal 104 and image interference signal 105 having a phase of $(-\pi/3)$ radian and a phase of $(-\pi/3)$ radian, respectively.

From Mathematical Formula 7 above, output 74a of phase shifter 74 outputs desired signal 106 and image interference signal 107 having a phase of 0 radian and a phase of $(+2\pi/3)$ radian, respectively.

Secondly, one input 72a of mixer 72 receives desired signal 101 and image interference signal 102. The other input 72b of mixer 72 receives signal 113 which is phase-shifted by $(-\pi/3)$ radian with respect to oscillation signal 103.

From Mathematical Formula 8 above, output 72c of mixer 72 outputs desired signal 114 and image interference signal 115 having a phase of $(-2\pi/3)$ radian and a phase of $(+2\pi/3)$ radian, respectively.

From Mathematical Formula 9 above, output 75a of phase shifter 75 outputs desired signal 116 and image interference signal 117 having a phase of 0 radian and a phase of $(-2\pi/3)$ radian, respectively.

Thirdly, one input 73a of mixer 73 receives desired signal 101 and image interference signal 102. The other input 73b of mixer 73 receives oscillation signal 123, which is phase-shifted by $(-\pi/3)$ radian with respect to oscillation signal 113.

From Mathematical Formula 10 above, output 73c of mixer 73 outputs desired signal 124 and image interference signal 125 each having a phase of $(-\pi)$ radian.

From Mathematical Formula 11 above, output 76a of phase shifter 76 outputs desired signal 126 and image interference signal 127 each having a phase of 0 radian.

Finally, output terminal 32b outputs desired signal 128 as an IF component, which is formed by combining desired signals 106, 116, and 126. Desired signals 106, 116, and 126 are in-phase with each other, so that desired signal 128 is outputted with a magnitude three times larger than desired signals 106, 116, and 126.

On the other hand, output terminal 32b outputs image interference signals 107, 117, and 127. These image interference signals are cancelled because of having a phase difference of $(2\pi/3)$ radian from each other. As a result, the image interference signals are not outputted from output terminal 32b.

The following is a description, with reference to calculation formulas, of the case where input terminal 32a receives interference signals $V_{m1}$ and $V_{m2}$. The interference signal $V_{m1}$ is a signal having a frequency lower by the IF than the frequency three times the fundamental frequency of ring oscillation circuit 33. The interference signal $V_{m2}$ is a signal having a frequency higher by the IF than the frequency three times the fundamental frequency of ring oscillation circuit 33.

The interference signal $V_{m1}$ is expressed by Mathematical Formula 13 below.

$$V_{m1} = \sin(\omega_4 t - \theta_4), \qquad (13)$$

where $\omega_4$ is an angular frequency, and $\theta_4$ is a phase angle.

The interference signal $V_{m2}$ is expressed by Mathematical Formula 14 below.

$$V_{m2} = \sin(\omega_5 t - \theta_5), \qquad (14)$$

where $\omega_5$ is an angular frequency and $\theta_5$ is a phase angle.

The third harmonic component $V_{L3}$ (71b), which is the output of differential amplifier 51, is expressed by Mathematical Formula 15 below.

$$V_{L3}(71b) = \sin(3\omega_2 t - 3\theta_2 - \pi), \qquad (15)$$

where $\omega_2$ is an angular frequency and $\theta_2$ is a phase angle.

The third harmonic component $V_{L3}$ (72b), which is the output of differential amplifier 52 is expressed by Mathematical Formula 16 below.

$$V_{L3}(72b) = \sin(3\omega_2 t - 3\theta_2). \qquad (16)$$

The third harmonic component $V_{L3}$ (73b), which is the output of differential amplifier 53 is expressed by Mathematical Formula 17 below.

$$V_{L3}(73b) = \sin(3\omega_2 t - 3\theta_2 - \pi). \qquad (17)$$

First, one input 71a of mixer 71 receives the interference signals $V_{m1}$ and $V_{m2}$, which are divided to three mixers 71 to 73. The other input 71b of mixer 71 receives the third harmonic component $V_{L3}$ (71b). Consequently, an IF signal $V_3$ (71c) expressed by Mathematical Formula 18 below is outputted to output 71c of mixer 71.

$$V_3(71c) = 1/3 \times (V_{m1}+V_{m2}) \times V_{L3}(71b)$$
$$= 1/3 \times (1/2 \times \cos(3\omega_2 t - \omega_4 t + \theta_4 - 3\theta_2 - \pi)$$
$$+ 1/2 \times \cos(\omega_5 t - 3\omega_2 t - \theta_5 + 3\theta_2 + \pi)). \qquad (18)$$

The IF signal $V_3$ (71c) is phase-shifted by $(-2\pi + \pi/3)$ radian by phase shifter 74. Consequently, an IF signal $V_3$ (74a) expressed by Mathematical Formula 19 below is outputted to output 74a of phase shifter 74.

$$V_3(74a) = 1/3 \times (1/2 \times \cos(3\omega_2 t - \omega_4 t + \theta_4 - 3\theta_2 - 2\pi/3)$$
$$+ 1/2 \times \cos(\omega_5 t - 3\omega_2 t - \theta_5 + 3\theta_2 - 2\pi/3)). \qquad (19)$$

Secondly, one input 72a of mixer 72 receives the interference signals $V_{m1}$ and $V_{m2}$ divided to three mixers 71 to 73. The other input 72b receives the third harmonic component $V_{L3}$ (72b). Consequently, an IF signal $V_3$ (72c) expressed by Mathematical Formula 20 below is outputted to output 72c of mixer 72.

$$V_3(72c) = 1/3 \times (V_{m1}+V_{m2}) \times V_{L3} \ (72b)$$
$$= 1/3 \times (1/2 \times \cos(3\omega_2 t - \omega_4 t + \theta_4 - 3\theta_2)$$
$$+ 1/2 \times \cos(\omega_5 t - 3\omega_2 t - \theta_5 + 3\theta_2)). \qquad (20)$$

The IF signal $V_3$ (72c) is phase-shifted by $(-2\pi + 2\pi/3)$ radian by phase shifter 75. Consequently, an IF signal $V_3$ (75a) expressed by Mathematical Formula 21 below is outputted to output 75a of phase shifter 75.

$$V_3(75a) = 1/3 \times (1/2 \times \cos(3\omega_2 t - \omega_4 t + \theta_4 - 3\theta_2 + 2\pi/3)$$
$$+ 1/2 \times \cos(\omega_5 t - 3\omega_2 t - \theta_5 + 3\theta_2 + 2\pi/3)). \qquad (21)$$

Thirdly, one input 73a of mixer 73 receives the interference signals $V_{m1}$ and $V_{m2}$ divided to three mixers 71 to 73. The other input 73b of mixer 73 receives the third harmonic component $V_{L3}$ (73b). Consequently, an IF signal $V_3$ (73c) expressed by Mathematical Formula 22 below is outputted to output 73c of mixer 73.

$$V_3(73c) = 1/3 \times (V_{m1}+V_{m2}) \times V_{L3} \ (73b)$$
$$= 1/3 \times (1/2 \times \cos(3\omega_2 t - \omega_4 t + \theta_4 - 3\theta_2 - \pi)$$
$$+ 1/2 \times \cos(\omega_5 t - 3\omega_2 t - \theta_5 + 3\theta_2 + \pi)). \qquad (22)$$

The IF signal $V_3$ (73c) is phase-shifted by $(-2\pi + 3\pi/3)$ radian by phase shifter 76. Consequently, an IF signal $V_3$ (76a) expressed by Mathematical Formula 23 below is outputted to output 76a of phase shifter 76.

$$V_3(76a) = 1/3 \times (1/2 \times \cos(3\omega_2 t - \omega_4 t + \theta_4 - 3\theta_2)$$
$$+ 1/2 \times \cos(\omega_5 t - 3\omega_2 t - \theta_5 + 3\theta_2)). \qquad (23)$$

Finally, output terminal 32b outputs an IF component $V_3$ (32b), which is a combination of the IF signals $V_3$ (74a), $V_3$ (75a) and $V_3$ (76a), and is expressed by Mathematical Formula 24 below.

$$V_3(32b) = V_3(74a) + V_3(75a) + V_3(76a)$$

$$= 0. \qquad\qquad (24)$$

As apparent from Mathematical Formula 24, the first terms of the IF signals $V_3$ (74a), $V_3$ (75a), and $V_3$ (76a), which are the IF components of the interference signal $V_{m1}$, have a phase difference of ($2\pi/3$) radian from each other. As a result, these IF signals are cancelled.

On the other hand, the second terms of the IF signals $V_3$ (74a), $V_3$ (75a), and $V_3$ (76a), which are the IF components of the interference signal $V_{m2}$ have a phase difference of ($2\pi/3$) radian from each other. As a result, these IF signals are cancelled.

Therefore, the IF components of the interference signals $V_{m1}$ and $V_{m2}$ are not outputted from output terminal 32b.

Fig. 3 is a diagram of the phases of interference signals related to the frequency three times the fundamental frequency of ring oscillation circuit 33 of mixing device 31.

The diagram shows the phases of the interference signals having a frequency higher or lower by the IF than the frequency three times the fundamental frequency of ring oscillation circuit 33 at each point of mixers 71, 72, and 73 and does not show their magnitudes. The interference signals $V_{m1}$ are shown in solid lines, and the interference signals $V_{m2}$ are shown in dotted lines.

The following is a detailed description, with reference to Fig. 3, of how to cancel the interference signals related to the frequency three times the fundamental frequency of ring oscillation circuit 33 of mixing device 31.

First, the interference signals $V_{m1}$ and $V_{m2}$ to be inputted to one input 71a of mixer 71 are expressed by signal 201 and signal 202, respectively. From Mathematical Formula 15 above, the third harmonic component $V_{L3}$ (71b) to be inputted to input 71b of mixer 71 can be expressed by signal 203.

As apparent from Mathematical Formula 18 above, the interference signals $V_{m1}$ and $V_{m2}$ to be outputted from output 71c of mixer 71 can be expressed by signals 204 and 205, respectively.

As apparent from Mathematical Formula 19 above, the interference signals $V_{m1}$ and $V_{m2}$ to be outputted from output 74a of phase shifter 74 are expressed by signals 206 and 207, respectively.

Secondly, the interference signals $V_{m1}$ and $V_{m2}$ to be inputted to one input 72a of mixer 72 Can be expressed by signals 201 and 202. From Mathematical Formula 16 above, the third harmonic component $V_{L3}$ (72b) to be inputted to input 72b of mixer 72 can be expressed by signal 213.

As apparent from Mathematical Formula 20 above, the interference signals $V_{m1}$ and $V_{m2}$ to be outputted from output 72c of mixer 72 can be expressed by signals 214 and 215, respectively.

As apparent from Mathematical Formula 21 above, the interference signals $V_{m1}$ and $V_{m2}$ to be outputted from output 75a of phase shifter 75 are expressed by signals 216 and 217, respectively.

Thirdly, the interference signals $V_{m1}$ and $V_{m2}$ to be inputted to one input 73a of mixer 73 are signals 201 and 202, respectively. From Mathematical Formula 17 above, the third harmonic component $V_{L3}$ (73b) to be inputted to input 73b of mixer 73 can be expressed by signal 223.

As apparent from Mathematical Formula 22 above, the interference signals $V_{m1}$ and $V_{m2}$ to be outputted from output 73c of mixer 73 can be expressed by signals 224 and 225, respectively.

As apparent from Mathematical Formula 23 above, the interference signals $V_{m1}$ and $V_{m2}$ to be outputted from output 76a of phase shifter 76 can be expressed by signals 226 and 227, respectively.

Finally, the interference signal $V_{m1}$ to be outputted from output terminal 32b is a combined signal of signals 206, 216, and 226. These signals are cancelled because of having a phase difference of ($2\pi/3$) radian from each other.

The interference signal $V_{m2}$ to be outputted from output terminal 32b is a combined signal of signals 207, 217, and 227. These signals are cancelled because of having a phase difference of ($2\pi/3$) radian from each other.

As a result, the interference signals $V_{m1}$ and $V_{m2}$ are not outputted from output terminal 32b.

In general, in an oscillation circuit, the harmonic components of even number times the fundamental output component of ring oscillation circuit 33 are comparatively small, while the harmonic components of odd number times the fundamental output component are large. Therefore, the third and firth harmonic components, which are close to the fundamental output component of ring oscillation circuit 33, are outputted with a large magnitude. When interference signals are present in the frequencies higher or lower by the IF than these harmonic components, the frequencies are not received in satisfactory condition or might not be able to be received.

Even if the harmonic components of ring oscillation circuit 33 are smaller than the fundamental output component, the amplifiers or the limiter circuits contained in mixers 71, 72, and 73 which are the subsequent stages generate harmonic components.

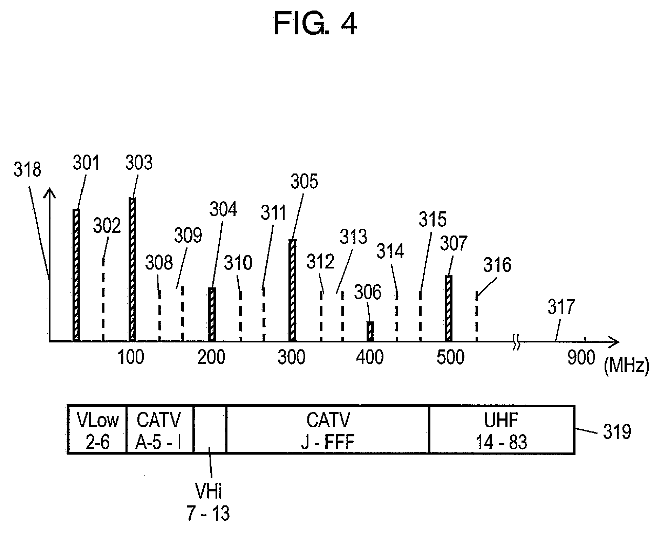

Fig. 4 is a relation diagram between broadcast channels available in North America and the interference signals related to the higher order harmonic frequencies of the oscillator.

In Fig. 4, horizontal axis 317 represents frequency, and vertical axis 318 represents signal magnitude. Frequency band 319 shows the TV and CATV broadcast channels available in North America. As shown in Frequency band 319, frequencies 50 MHz to 900 MHz are used in North America. When channel 2, which is in a Vlow(VHF low) band, is received, fundamental frequency 303 of ring oscillation circuit 33 is about 100 MHz. Fig. 4 includes desired signal 302 of about 55 MHz to be inputted to input terminal 32a, image interference signal 308, and IF signal 301 of output terminal 32b.

Fig. 4 further includes frequency components 304, 305, 306, and 307 whose frequencies are two, three, four, and five times, respectively, fundamental frequency 303. Fig. 4 further includes frequency components 309 and 310 which are lower and higher, respectively, by the IF than frequency component 304 whose frequency is two times fundamental frequency 303; frequency components 311 and 312 which are lower and higher, respectively, by the IF than frequency component 305 whose frequency is three times fundamental frequency 303; frequency components 313 and 314 which are lower and higher, respectively, by the IF than frequency component 306 whose frequency is four times fundamental frequency 303; frequency components 315 and 316 which are lower and higher, respectively, by the IF than frequency component 307 whose frequency is five times fundamental frequency 303.

At this moment, frequency components 311, 312, and 315 fall within the CATV channels. Frequency components 311 and 312 are lower and higher, respectively, by the IF than frequency component 305 whose frequency is three times fundamental frequency 303, and frequency component 315 is lower by the IF than frequency component 307 whose frequency is five times fundamental frequency 303. On the other hand, frequency component 316 which is higher by the IF than frequency component 307 whose frequency is five times fundamental frequency 303 falls within the UHF channels. Consequently, frequency components 311, 312, 315, and 316 become interference signals. This means that in the case of receiving a low frequency channel, the broadcast channels in the higher frequencies than the reception channel become interference signals. Furthermore, as lower frequency channels are received, more interference signals are included in the channels.

Table 1 below shows whether the interference signals related to the harmonic components generated by the fundamental output component of ring oscillation circuit 33 of mixing device 31 of the present embodiment can be suppressed or not. As mentioned above, the number of the mixers, "M", is 3 in the present embodiment.

Table 1

| | n×F0-IF | | n×F0+IF | |
|---|---|---|---|---|
| | input frequency | suppression effect | input frequency | suppression effect |
| n=1 | FO-IF | desired signal | image interference | ○ |
| n=3 | 3×F0-IF | ○ | 3×F0+IF | ○ |
| n=5 | 5×F0-IF | ○ | 5×F0+IF | × |
| n=7 | 7×F0-IF | × | 7×F0+IF | ○ |
| n=9 | 9×F0-IF | ○ | 9×F0+IF | ○ |
| n=11 | 11×F0-IF | ○ | 11×F0+IF | × |
| n=13 | 13×F0-IF | × | 13×F0+IF | ○ |
| : | : | : | : | : |

In Table 1, "F0" represents the fundamental frequency, and "n" represents a multiple number of the fundamental frequency of ring oscillation circuit 33. When "n" is 1, ring oscillation circuit 33 shows the fundamental frequency, and "fundamental frequency - F" and "fundamental frequency + IF" represent the frequency of a desired signal and the frequency of an image interference signal, respectively. The interference signal indicated by the symbol "circle" can be suppressed and eliminated, and the interference signals indicated by the symbol "cross" cannot be suppressed or eliminated.

When n = 3, the interference signals having a frequency corresponding to "3 × fundamental frequency + IF" or "3 × fundamental frequency - IF" can be suppressed.

When n = 5, the interference signal having a frequency corresponding to "5 × fundamental frequency - IF" can be suppressed.

In this manner, mixing device 31 can suppress an image interference signal; interference signals having a frequency higher or lower by the IF than the frequency three times the fundamental frequency of ring oscillation circuit 33; and interference signals having a frequency lower by the IF than the frequency five times the fundamental frequency of ring oscillation circuit 33. The output signals of differential amplifiers 51 to 56 can be supplied to the other inputs of mixers 71 to 73 to secure the suppression of the interference signals.

Differential amplifiers 51 to 56 of ring oscillation circuit 33 can output signals having exactly the same phase difference relative to each other by being formed of inverters having common properties. Then, the output signals of differential amplifiers 51 to 53 can be supplied to the other inputs of mixers 71 to 73.

Mixing device 31 that secures the suppression of these interference signals can be achieved by integrating differential amplifiers 51 to 56 having common properties and mixers 71 to 73 having common properties.

In other words, the output signals of differential amplifiers 51 to 56 in ring oscillation circuit 33 can have exactly the same phase difference relative to each other by employing inverters having common properties as differential amplifiers 51 to 56.

As described hereinbefore, mixing device 31 is formed of the combination of mixing circuit 32 and ring oscillation circuit 33 having differential amplifiers 51 to 56 connected in series to each other.

Thus employing ring oscillation circuit 33 as the oscillation circuit eliminates the need for tuning circuit 16, electronic switch 20, and phase shifters 7, 8, and 9 which are used in the conventional devices. The absence of tuning inductors 18a, 18b, and 18c occupying a large space in the integrated circuit makes it possible to provide a mixing device reduced in size to about one-fifth of the conventional devices. Mixing device 31 integrates at least mixing circuit 32 and ring oscillation circuit 33 in the same package 40 so as to reliably suppress interference signals and to be made compact. Package 40 may be made of plastic, ceramic, or the like, or made of a metal in order to prevent unnecessary radiation of electromagnetic waves.

It is also possible to change the oscillation frequency of ring oscillation circuit 33 to the oscillation frequency used to receive the UHF band by controlling the value of the voltage to be applied to power supply terminal 34 of ring oscillation circuit 33.

In the present embodiment, the oscillation signals of ring oscillation circuit 33 are inputted as balanced inputs to the other inputs 71b to 73b of mixers 71 to 73. It is alternatively possible to use the oscillation signals as unbalanced inputs, without establishing a connection between the other inputs 71b to 73b and input terminals 38 to 40.

## SECOND EMBODIMENT

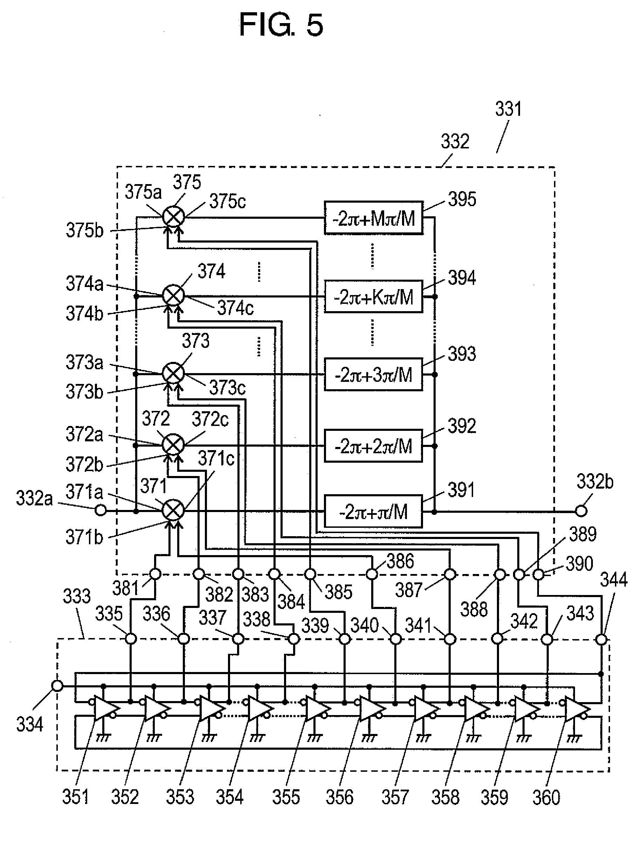

Fig. 5 is a block diagram of mixing device 331 according to a second embodiment of the present invention. In the first embodiment, mixing device 31 includes three mixers 71 to 73 and ring oscillation circuit 33 having six differential amplifiers 51 to 56 as shown in Fig. 1. Thus, the first embodiment is an example where "M" is 3. In contrast, in the present embodiment, mixing device 331 includes mixing circuit 332 having "M" mixers 371 to 375 and ring oscillation circuit 333 having (2 × M) differential amplifiers 351 to 360 as shown in Fig. 5. In the present embodiment, "M" is a natural number of 3 or more.

The different point of the present embodiment from the first embodiment enables to remove interference signals having a frequency higher or lower by the IF than the frequency three to (2M - 3) times the fundamental frequency of ring oscillation circuit 333.

In the present embodiment, only five mixers 371 to 375 are shown and the remaining ones of the "M" mixers are omitted in Fig. 5. The same holds true for phase shifters 391 to 395. Similarly, only ten differential amplifiers 351 to 360 are shown and the remaining ones of the (2 x M) differential amplifiers are omitted. For convenience of illustration, Fig. 5 shows the case where "M" is 5 or more. The following description is based on the assumption that "K" is 4 or more in accordance with the drawings; however, "K" can be 1 to "M" in the present invention. The present invention is applicable to the case where "M" is 3 or 4 although it differs from the case of Fig. 5. The case is not described any further.

The operation of mixing device 331 is briefly described as follows because it is fundamentally equal to that of mixing device 31 of the first embodiment.

As shown in Fig. 5, mixing device 331 includes mixing circuit 332 and ring oscillation circuit 333. Mixing circuit 332 has input terminal 332a for receiving a radio frequency signal, and output terminal 332b. Ring oscillation circuit 333 supplies an oscillation signal to mixing circuit 332. One input of mixing circuit 332 receives the radio frequency signal inputted to input terminal 332a. The other input of mixing circuit 332 is connected to ring oscillation circuit 333 so as to receive its output signal.

The structure of ring oscillation circuit 333 is described as follows. Ring oscillation circuit 333 includes a first ring oscillating part where (2 × M) differential amplifiers 351 to 360 for inverting and outputting input signals are connected in series in this order. Differential amplifiers 351 to 360 may be formed of (2 × M) inverters. In other words, the first ring oscillating part includes at least the first inverter to the (2 × M)th inverter.

The output of first differential amplifier 351 is connected to the input of second differential amplifier 352. The output of second differential amplifier 352 is connected to the input of third differential amplifier 353. The output of differential amplifier 353 is connected to the input of the differential amplifier (unillustrated) in the next stage. The output of the (k-1)th differential amplifier (unillustrated) when a serial connection is established between the differential amplifiers in the ((k - 1) - 3) stages is connected to the input of K-th differential amplifier 354. The output of K-th differential amplifier 354 is connected to the input of the differential amplifier (unillustrated) in the next stage. The output of the (M - 1)th differential amplifier (unillustrated) when a serial connection is established between the differential amplifiers (unillustrated) in the ((M - 1) - K) stages is connected to the input of M-th differential amplifier 355.

The output of M-th differential amplifier 355 is connected to the input of (M + 1)th differential amplifier 356. The output of (M + 1)th differential amplifier 356 is connected to the input of (M + 2)th differential amplifier 357. The output of (M + 2)th differential amplifier 357 is connected to the input of (M + 3)th differential amplifier 358. The output of (M + 3)th differential amplifier 358 is connected to the input of the differential amplifier (unillustrated) in the next stage. The output of the (M + K - 1)th differential amplifier (unillustrated) when a serial connection is established between the differential amplifiers (unillustrated) of the ((M + K - 1)-(M + 3)) stages is connected to the input of (M + K)th differential amplifier 359. The output of (M + K)th differential amplifier 359 is connected to the input of the differential amplifier (unillustrated) in the next stage. The output of (M+M- 1)th differential amplifier (unillustrated) when a serial connection is established between the differential amplifiers (unillustrated) in the ((M + M - 1) - (M + K - 1)) stages is connected to the input of(M + M)th differential amplifier 360. The output of (M + M)th differential amplifier 360 is connected to the input of first differential amplifier 351.

When "M" is 4, "K" is inevitably 4. Therefore, unlike the structure shown in the drawing, differential amplifiers 354 and 355 are identical to each other. Similarly, differential amplifiers 359 and 360 are identical to each other. This case is not described any further here.

The outputs of $(2 \times M)$ differential amplifiers 351 to 360 are connected to $(2 \times M)$ output terminals 335 to 344, respectively, of ring oscillation circuit 333. The power inputs of differential amplifiers 351 to 360 are all connected to power supply terminal 334.

The oscillation operation of ring oscillation circuit 333 thus structured is described as follows. In ring oscillation circuit 333, the input signal of differential amplifier 351 is inverted and amplified by differential amplifiers 351 to 360 and returns to the input of differential amplifier 351. The degree of amplification of the loop formed by differential amplifiers 351 to 360 is 1 or more. Consequently, ring oscillation circuit 333 has an oscillation frequency at which the phase delay is $(-2\pi)$ radian between the input signal of differential amplifier 351 and the output signal of differential amplifier 360.

The phase delay is determined as follows. The output currents of differential amplifiers 351 to 360 charge or discharge the input capacitors and input resistors of the differential amplifiers in the subsequent stages and the mixers connected to the outputs of differential amplifiers 351 to 360. The time required for the charge-discharge causes the phase delay. Consequently, the output signal of differential amplifier 351 is delayed in phase. The output signal of differential amplifier 352 is further delayed in phase. Similarly, the output signals of differential amplifiers 353 to 360 are sequentially delayed in phase.

The phases of the outputs of differential amplifiers 351 to 360 are described as follows. Differential amplifiers 351 to 360 may be formed of $(2 \times M)$ inverters. Therefore, the phase difference between the input and output of each inverter can be $(-\pi/M)$ radian, which is obtained by dividing the phase delay between the input signal of differential amplifier 351 and the output signal of differential amplifier 356 by the number of the inverters. In other words, the phase difference of $(-\pi/M)$ radian is obtained by dividing $(-2\pi)$ radian by $(2 \times M)$.

This means that the phase of the output signal is delayed by $(-\pi/M)$ radian from that of the input signal in each of differential amplifiers 351 to 360. As a result, the phases of the output signals of differential amplifiers 351 to 360 are delayed from that of the input signal of differential amplifier 351 by $(-\pi/M)$ radian, $(-2\pi/M)$ radian, $(-3\pi/M)$ radian, ..., $(-K\pi/M)$ radian, ..., $(-(M + K)\pi/M)$ radian, ..., and $(-2M\pi/M)$ radian, respectively.

These signals are balance-inputted to the other inputs of mixers 371 to 375 via output terminals 335 to 344, respectively. In other words, the oscillation signal that is phase-shifted by $(-K\pi/M)$ radian and outputted from the K-th inverter and the oscillation signal that is phase-shifted by $(-(M + K)\pi/M)$ radian and outputted from the (M + K)th inverter are balance-inputted to the other input of the K-th mixer.

The output currents of differential amplifiers 351 to 360 can be controlled by the value of the voltage applied to power supply terminal 334 so as to change the oscillation frequency of ring oscillation circuit 333. For example, when the voltage to be applied to power supply terminal 334 is controlled to be 0.5 to 3.0V, the oscillation frequency of ring oscillation circuit 333 can be changed to 450 to 1000 MHz, which are used to receive the UHF band.

The structure of mixing circuit 332 which receives the oscillation signal of ring oscillation circuit 333 is described as follows.

In Fig. 5, mixing circuit 332 includes input terminal 332a; "M" mixers 371 to 375; $(2 \times M)$ input terminals 381 to 390; and "M" phase shifters 391 to 395. "M" mixers 371 to 375 are connected to input terminal 332a at one input thereof. $(2 \times M)$ input terminals 381 to 390 are connected to the other inputs of mixers 371 to 375. "M" phase shifters 391 to 395 are connected between the outputs of mixers 371 to 375, respectively, and output terminal 332b so as to shift a phase of $(-2\pi + K\pi/M)$ radian.

First-stage mixer 371 is connected to input terminal 332a at one input 371a and to input terminals 381 and 386 at the other input 371b. Second-stage mixer 372 is connected to input terminal 332a at one input 372a and to input terminals 382 and 387 at the other input 372b. Third-stage mixer 373 is connected to input terminal 332a at one input 373a and to input terminals 383 and 388 at the other input 373b. K-th-stage mixer 374 is connected to input terminal 332a at one input 374a and to input terminals 384 and 389 at the other input 374b. M-th-stage mixer 375 is connected to input terminal 332a at one input 375a and at to input terminals 385 and 390 the other input 375b.

The operation of mixing device 331 thus structured is described using calculation formulas.

The radio frequency signal inputted to input terminal 332a is connected to one inputs 371a to 375a of mixers 371 to 375. The other inputs 371b to 375b of mixers 371 to 375 are supplied with output signals which are phase-shifted by $(-\pi- K\pi/M)$ radian each from ring oscillation circuit 333. "M" is a natural number of 3 or more and "K" is a natural number of 1 to "M".

Between outputs 371c to 375c of "M" mixers 371 to 375 and output terminal 332b are connected phase shifters 391 to 395, respectively, having a phase shift amount of $(-2\pi + K\pi/M)$ radian.

The following is a description of the case where input terminal 332a receives a desired signal. In this case, one inputs 371a to 375a of "M" mixers 371 to 375 receive the desired signal, while the other inputs 371b to 375b of "M" mixers 371 to 375 receive output signals of ring oscillation circuit 333, the output signals being phase-shifted by $(-K\pi/M)$ radian.

Outputs 371c to 375c of mixers 371 to 375 each output a desired signal which is phase-shifted by $(-K\pi/M)$ radian. The desired signals thus phase-shifted by $(-K\pi/M)$ radian are further phase-shifted by $(-2\pi + K\pi/M)$ radian by phase shifters 391 to 395, respectively. As a result, the desired signal at output terminal 332b has a phase $\theta_d$ of $(-2\pi)$ radian as shown in Mathematical Formula 25 below. In other words, phase shifters 391 to 395 output the desired signals which have a phase shift of 0 radian and are in-phase with each other.

$$\theta_d = -K\pi/M - 2\pi + K\pi/M$$
$$= -2\pi. \tag{25}$$

Thus, the IF component of the desired signal is multiplied by "M" and outputted from output terminal 332b.

The following is a description of the case where input terminal 332a receives an image interference signal. In this case, one inputs 371a to 375a of mixers 371 to 375 receive the image interference signal, while the other inputs 371b to 375b of mixers 371 to 375 receive output signals of ring oscillation circuit 333, the output signals being phase-shifted by $(-K\pi/M)$ radian.

Outputs 371c to 375c of mixers 371 to 375 each output an image interference signal which is phase-shifted by $(+K\pi/M)$ radian because its frequency is higher than that of ring oscillation circuit 333. The image interference signals thus phase-shifted by $(-t-K\pi/M)$ radian are further phase-shifted by $(-2\pi + K\pi/M)$ radian by phase shifters 391 to 395, respectively. As a result, the image interference signal at output terminal 332b has a phase $\theta_i$, shown in Mathematical Formula 26 below.

$$\theta_i = K\pi/M - 2\pi + K\pi/M$$
$$= K2\pi/M. \tag{26}$$

Thus, the phase $\theta_i$ includes components each having a phase of $(K \times 2\pi/M)$ radian. Therefore, output terminal 332b has "M" components obtained by dividing $2\pi$ into "M", so that the image interference signal is phase cancelled. In other words, the image interference signal has an IF component of 0 and is not outputted from output terminal 332b.

The following is a description of the case where input terminal 332a receives, as an interference signal, a signal having a frequency higher or lower by the IF than the frequency "n" times the fundamental frequency of ring oscillation circuit 333. One inputs 371a to 375a of "M" mixers 371 to 375 receive this interference signal, while the other inputs 371b to 375b of "M" mixers 371 to 375 receive output signals of ring oscillation circuit 333, the output signals being phase-shifted by $(-K\pi/M)$ radian.

Outputs 371c to 375c of mixers 371 to 375 output interference signals having a frequency higher or lower by the IF than the frequency "n" times the fundamental frequency of ring oscillation circuit 333. The interference signals are phase-shifted by $(K\pi n/M)$ radian or $(-K\pi n/M)$ radian. The signals thus phase-shifted by $(K\pi n/M)$ radian or $(-K\pi n/M)$ radian are further phase-shifted by $(-2\pi + K\pi/M)$ radian by phase shifters 391 to 395, respectively.

As a result, when an interference signal having a frequency lower by the IF than the frequency "n" times the fundamental frequency of ring oscillation circuit 333 is received, output terminal 332b outputs a spurious signal having a phase $\theta_{m1}$ shown in Mathematical Formula 27 below.

$$\theta_{m1} = -K\pi n/M - 2\pi + K\pi/M$$

$$= K\pi(1-n)/M. \tag{27}$$

On the other hand, when an interference signal having a frequency higher by the IF than the frequency "n" times the fundamental frequency of ring oscillation circuit 333 is received, output terminal 332b outputs a spurious signal having a phase $\theta_{m2}$ shown in Mathematical Formula 28 below.

$$\theta_{m2} = K\pi n/M - 2\pi + K\pi/M$$

$$= K\pi(1+n)/M. \tag{28}$$

When the number of the mixers is 5 ("M" = 5), and "n" which is the multiple number of the fundamental frequency of ring oscillation circuit 333 is 5, the phase $\theta_{m1}$ = -K$\pi$4/5 radian and the phase $\theta_{m2}$ = K$\pi$6/5 radian. This means that there are five signals having a phase obtained by dividing (4$\pi$) radian or (6$\pi$) radian by 5 so as to achieve phase cancellation.
When the number of the mixers is 5 ("M" = 5), and "n" which is the multiple number of the fundamental frequency of ring oscillation circuit 333 is 9, phase $\theta_{m1}$ = -K$\pi$8/5 radian and phase $\theta_{m2}$ = K$\pi$10/5 radian. Since (K$\pi$10/5) radian, that is, (K2$\pi$) radian means that there are five signals ("K" = 5) which are in-phase with each other, they are not phase-cancelled. On the other hand, (K$\pi$8/5) radian means that there are five signals ("K" = 5) having a phase obtained by dividing (8$\pi$) radian by 5, so that they are phase-cancelled.
Table 2 below shows the degree of suppression of the interference signals related to the harmonic components generated from the fundamental output component of ring oscillation circuit 333 in the mixing device of the present embodiment.

Table 2

| | n×F0-IF | | n×F0+IF | |
|---|---|---|---|---|
| | input frequency | suppression effect | input frequency | suppression effect |
| n=1 | F0-IF | desired signal | image interference | ○ |
| n=3 | 3×F0-IF | ○ | 3×F0+IF | ○ |
| n=5 | 5×F0-IF | ○ | 5×F0+IF | ○ |
| n=7 | 7×F0-IF | ○ | 7×F0+IF | ○ |
| n=9 | 9×F0-IF | ○ | 9×F0+IF | × |
| n=11 | 11×F0-IF | × | 11×F0+IF | ○ |
| n=13 | 13×F0-IF | ○ | 13×F0+IF | ○ |
| : | : | : | : | : |

In Table 2, "F0" represents the fundamental frequency, and the number of the mixers is 5 ("M" = 5) in the mixing device of the present embodiment. As a result, the following signals are phase-cancelled and suppressed: an image interference signal; interference signals having a frequency higher or lower by the IF than the frequency three, five, and seven times the fundamental frequency of ring oscillation circuit 333; and interference signals having a frequency lower by the IF than the frequency nine times the fundamental frequency of ring oscillation circuit 333. The interference signals indicated by the symbol "circle" can be suppressed and eliminated, and the interference signals indicated by the symbol "cross" cannot be suppressed or eliminated.
Table 3 below shows the degree of suppression of the interference signals related to the harmonic components generated from the fundamental output component of ring oscillation circuit 333 in the mixing device of the present embodiment. In table 3, the number of the mixers is "M".

Table 3

| | n × F0-IF | | n × F0+IF | |
|---|---|---|---|---|
| | input frequency | suppression effect | input frequency | suppression effect |
| n=1 | FO-IF | desired signal | image interference | ○ |
| n=3 | 3×F0-IF | ○ | 3×F0+IF | ○ |
| n=5 | 5×F0-IF | ○ | 5×F0+IF | ○ |
| n=7 | 7×F0-IF | ○ | 7×F0+IF | ○ |
| n=9 | 9×F0-IF | ○ | 9×F0+IF | ○ |
| n=11 | 11×F0-IF | ○ | 11×F0+IF | ○ |
| n=13 | 13×F0-IF | ○ | 13×F0+IF | ○ |
| : | : | : | : | : |
| n=2M-3 | (2M-3)×F0-IF | ○ | (2M-3)×F0+IF | ○ |
| n=2M-2 | (2M-2)×F0-IF | ○ | (2M-2)×F0+IF | × |
| n=2M-1 | (2M-1)×F0-IF | × | (2M-1)×F0+IF | ○ |
| : | : | : | : | : |

In Table 3, "F0" represents the fundamental frequency, and in mixing device 331 having the "M" mixers, the following signals are phase-cancelled and suppressed: an image interference signal; and interference signals having a frequency higher or lower by the IF than the frequency three to (2M - 3) times the fundamental frequency of ring oscillation circuit 333. On the other hand, the interference signals having a frequency higher or lower by the IF than the frequency (2M - 2) times the fundamental frequency may or may not be suppressed. The interference signals indicated by the symbol "circle" can be suppressed and eliminated, and the interference signals indicated by the symbol "cross" cannot be suppressed or eliminated.

In this manner, mixing device 331 can suppress the image interference signal; the interference signals having a frequency higher or lower by the IF than the frequency three times the fundamental frequency of ring oscillation circuit 333; and the interference signals having a frequency lower by the IF than the frequency five times the fundamental frequency of ring oscillation circuit 333.

Mixing device 331 that secures the suppression of these interference signals can be achieved by integrating differential amplifiers 351 to 360 having common properties and mixers 371 to 375 having common properties.

In other words, the output signals of differential amplifiers 351 to 360 in ring oscillation circuit 333 can have exactly the same phase difference relative to each other by employing differential amplifiers having common properties as differential amplifiers 351 to 360.

As described above, mixing device 331 is formed of the combination of mixing circuit 332 including "M" mixers 371 to 375, and ring oscillation circuit 333 including 2M differential amplifiers 351 to 360.

Thus employing ring oscillation circuit 333 as the oscillation circuit eliminates the need for tuning circuit 16, electronic switch 20, and phase shifters 7, 8, and 9 which are used in the conventional devices. The absence of tuning inductors 18a, 18b, and 18c occupying a large space in the integrated circuit makes it possible to provide a mixing device reduced in size to about one-fifth of the conventional devices.

It is also possible to change the oscillation frequency of ring oscillation circuit 333 to the oscillation frequency used to receive the UHF band by controlling the value of the voltage to be applied to power supply terminal 334 of ring oscillation circuit 333.

This allows mixing device 331 to be compact and also a radio-frequency receiver using mixing device 331 to be small in size and cost because of low attenuation characteristics of filter 603 connected to the input of mixing device 331.

In the present embodiment, the oscillation signals of ring oscillation circuit 333 are inputted as balanced inputs to the other inputs 371b to 375b of mixers 371 to 375. It is alternatively possible to use the oscillation signals as unbalanced inputs, without establishing a connection between the other inputs 371b to 375b and input terminals 386 to 390.

In this case, it is possible to connect differential amplifiers 351 to 355 in series, and to connect phase shifter 361 (unillustrated) between the output of differential amplifier 355 and the input of differential amplifier 351 in ring oscillation circuit 333. Then, the phase shift amount of phase shifter 361 can be set to π radian. This allows "M" differential amplifiers 356 to 360 to be replaced by phase shifter 361, thereby providing a compact mixing device.

**THIRD EMBODIMENT**

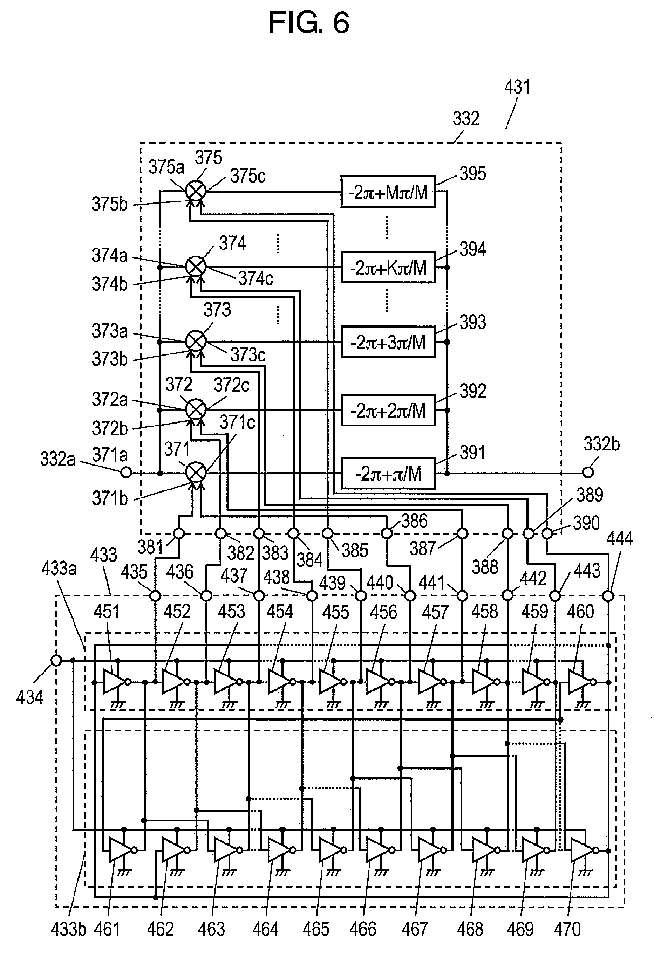

Fig. 6 is a block diagram of mixing device 431 according to a third embodiment of the present invention. In the second embodiment, ring oscillation circuit 333 includes (2 × M) differential amplifiers 351 to 360 connected in series as shown in Fig. 5. In contrast, in the present embodiment, as shown in Fig. 6, ring oscillation circuit 433 includes (4 × M) inverters 451 to 470 where "M" is a natural number of 3 or more. The different point of the present embodiment from the second embodiment enables to reduce phase noise by using inverters 451 to 470. As a result, mixing device 431 has a high receiving sensitivity.

In the present embodiment, only five mixers 371 to 375 are shown and the remaining ones of the "M" mixers are omitted in Fig. 6. Similarly, only 20 inverters 451 to 470 are shown and the remaining ones of the (4 × M) inverters are omitted. For convenience of illustration, Fig. 6 shows the case where "M" is 5 or more. The following description is based on the assumption that "K" is 4 or more in accordance with the drawings; however, "K" can be 1 to "M" in the present invention. The present invention is applicable to the case where "M" is 3 or 4 although it differs from the case of Fig. 6. The case is not described any further.

The operation of mixing device 431 is briefly described as follows because it is fundamentally equal to that of mixing device 31 of the first embodiment.

As shown in Fig. 6, mixing device 431 includes mixing circuit 332 and ring oscillation circuit 433. Mixing circuit 332 has input terminal 332a for receiving a radio frequency signal, and output terminal 332b. Ring oscillation circuit 433 supplies an oscillation signal to mixing circuit 332.

The structure of ring oscillation circuit 433 is described as follows. Ring oscillation circuit 433 includes first ring oscillating part 433a and second ring oscillating part 433b.

First, the structure of first ring oscillating part 433a is described in detail as follows. First ring oscillating part 433a includes (2 × M) inverters 451 to 460 which invert and output input signals and are connected in series in this order in a ring shape. More specifically, the output of first inverter 451 is connected to the input of second inverter 452. The output of second inverter 452 is connected to the input of third inverter 453. The output of third inverter 453 is connected to the input of the inverter (unillustrated) in the next stage. The output of the (K - 1)th inverter (unillustrated) when a serial connection is established between the inverters in the ((k - 1) - 3) stages is connected to the input of K-th inverter 454. The output of K-th inverter 454 is connected to the input of the inverter (unillustrated) in the next stage. The output of the (M - 1)th inverter (unillustrated) when a serial connection is established between the inverters (unillustrated) in the ((M - 1) - K) stages is connected to the input of M-th inverter 455.

The output of M-th inverter 455 is connected to the input of (M + 1)th inverter 456. The output of (M + 1)th inverter 456 is connected to the input of (M +2)th inverter 457. The output of (M + 2)th inverter 457 is connected to the input of (M + 3)th inverter 458. The output of (M + 3)th inverter 458 is connected to the input of the inverter (unillustrated) in the next stage. The output of (M + K - 1)th inverter (unillustrated) when a serial connection is established between the inverters (unillustrated) in the ((M+ K - 1) - (K+3)) stages is connected to the input of (M + K)th inverter 459. The output of (M + K)th inverter 459 is connected to the input of the inverter (unillustrated) in the next stage. The output of the (M+M- 1)th inverter (unillustrated) when a serial connection is established between the inverters (unillustrated) in the ((M + M - 1)-(M + K)) stages is connected to the input of (M + M)th inverter 460. The output of (M + M)th inverter 460 is connected to the input of first inverter 451.

Next, the structure of second ring oscillating part 433b is described in detail as follows. Second ring oscillating part 433b includes (2 x M) inverters 461 to 470 for inverting and outputting input signals. The output of first inverter 461 is connected to the output of inverter 451 and to the input of third inverter 463. The output of third inverter 463 is connected to the output of inverter 453 and also connected to the input of M-th inverter 465 via the (M - 2)th inverter (unillustrated) of the inverters connected in series in the ((M - 2)-3)) stages. The output of M-th inverter 465 is connected to the output of inverter 455 and to the input of (M + 2)th inverter 467. The output of (M + 2)th inverter 467 is connected to the output of inverter 457 and also connected to the input of (M + K)th inverter 469 via the (M + K - 2)th inverter (unillustrated) of the inverters connected in series in the ((M + K - 2)-(M + 2)) stages. The output of (M + K)th inverter 469 is connected to the output of inverter 459 and also connected to the input of (M + K + 2)th inverter (unillustrated) where "K" is (M - 2) or less. The input of first inverter 461 is connected to the output of the (M + M - 1)th inverter (unillustrated).

The output of second inverter 462 is connected to the output of inverter 452 and also connected to the input of K-th inverter 464 via the (K-2)th inverter (unillustrated) of the inverters connected in series in the ((K-2)-2) stages. The output of K-th inverter 464 is connected to the output of inverter 454 and also connected to the input of (M + 1)th inverter 466 via (M - 1)th inverter (unillustrated) of the inverters connected in series in the ((M - 1) - K) stages. The output of (M + 1)th inverter 466 is connected to the output of inverter 456 and to the input of (M + 3)th inverter 468. The output of (M + 3)th inverter 468 is connected to the output of inverter 458 and also connected to the input of (M + M)th inverter 470 via the (M + M - 2)th inverter (unillustrated) of the inverters connected in series in the ((M+M - 2)-(M + 3)) stages. The output of (M + M) th inverter 470 is connected to the output of inverter 460, the input of second inverter 462, and the input of inverter 451.

In other words, ring oscillation circuit 433 includes first ring oscillating part 433a and second ring oscillating part 433b. First ring oscillating part 433a includes first inverter 451 to the L-th inverter where "L" is a natural number of 1 to 2M, the (L + 2)th inverter to the (M + M - 1)th inverter, and (M + M)th inverter 460.

Second ring oscillating part 433b includes first inverter 461 to the L-th inverter, the (L + 2)th inverter to the (M

+M - 1)th inverter, and (M + M)th inverter 470.

The output of the L-th inverter included in first ring oscillating part 433a is connected to the output of the L-th inverter included in second ring oscillating part 433b.

When "L" is equal to or less than (M + M - 2), the output of the L-th inverter included in second ring oscillating part 433b is connected to the input of the (L + 2)th inverter included in second ring oscillating part 433b.

When "L" is equal to (M + M - 1), the output of (M + M - 1)th inverter (unillustrated) included in second ring oscillating part 433b is connected to the input of first inverter 461 included in second ring oscillating part 433b.

When "L" is equal to (M + M), the output of (M + M)th inverter 570 included in second ring oscillating part 433b; the input of first inverter 451 included in first ring oscillating part 433a; and the input of second inverter 462 included in second ring oscillating part 433b are connected to each other.

When "M" is 4, "K" is inevitably 4. Therefore, unlike the structure shown in the drawing, inverters 454 and 455 are identical to each other. Similarly, inverters 459 and 460 are identical to each other; inverters 464 and 465 are identical to each other; and inverters 469 and 470 are identical to each other. This case is not described any further here.

The outputs of inverters 451 to 460 are connected to ($2 \times M$) output terminals 435 to 444, respectively, of ring oscillation circuit 433. Output terminals 435 to 444 are connected as balanced inputs to the other inputs of mixers 371 to 375.

The power inputs of inverters 451 to 470 are all connected to power supply terminal 434.

The oscillation operation of ring oscillation circuit 433 thus structured is described as follows. In first ring oscillating part 433a, the input signal of inverter 451 is inverted and amplified by inverters 451 to 460 and returns to the input of inverter 451. In second ring oscillating part 433b, the output signal of inverter 461 is connected to the output signal of inverter 451. The input of inverter 461 receives the output signal of the inverter (unillustrated), which is in the stage before the previous stage of inverter 451.

Similarly, the output signals of inverters 452 to 460 are connected to the output signals of the corresponding inverters 462 to 470. The inputs of inverters 462 to 470 receive the output signals of inverters 460 to 458, which are in the stage before the previous stage of inverters 452 to 460.

As a result, the input to each of the inverters forming first ring oscillating part 433a is the sum of the output signal of the inverter in the previous stage and the output signal of the inverter included in second ring oscillating part 433b which has received the output signal of the inverter in the stage before the previous stage. As a result, ring oscillation circuit 433 is not placed in the state in which ring oscillation circuit 433 does not oscillate.

Ring oscillation circuit 433 can oscillate when the degree of amplification of the loop formed by first and second ring oscillating parts 433a and 433b is 1 or more and ring oscillation circuit 433 has an oscillation frequency at which the phase delay is ($-2\pi$) radian between the input signal of inverter 451 and the output signal of inverter 460.

The phase delay is determined as follows. The output currents of inverters 451 to 460 charge or discharge the input capacitors and input resistors of the inverters in the subsequent stages and the mixers connected to the outputs of inverters 451 to 460. The time required for the charge-discharge causes the phase delay.

Consequently, the output signal of inverter 451 is delayed in phase. The output signal of inverter 452 is further delayed in phase. In the same manner, the output signals of inverters 453 to 460 are sequentially delayed in phase.

The phases of the outputs of inverters 451 to 460 are described as follows. Inverters 451 to 460 are formed of ($2 \times M$) inverters. Therefore, the phase difference between the input and output of each inverter can be ($-2\pi/2M$) radian, that is, ($-\pi/M$) radian, which is obtained by dividing the phase delay between the input signal of inverter 451 and the output signal of inverter 456 by the number of the inverters. In other words, the phase difference of ($-\pi/M$) radian is obtained by dividing ($-2\pi$) radian by ($2 \times M$).

This means that the phase of the output signal is delayed by ($-K\pi/M$) radian from that of the input signal in each of inverters 451 to 460. As a result, the phases of the output signals of inverters 451 to 460 are delayed from that of the input signal of inverter 451 by ($-\pi/M$) radian, ($-2\pi/M$) radian, ($-3\pi/M$) radian, ..., ($-K\pi/M$) radian, ..., and ($-2M\pi/M$) radian, respectively.

These signals are balance-inputted to the other inputs 371b to 375b of mixers 371 to 375 via output terminals 435 to 444, respectively.

The output currents of inverters 451 to 470 forming ring oscillation circuit 433 can be controlled by the value of the voltage applied to power supply terminal 434 so as to change the oscillation frequency of ring oscillation circuit 433. For example, when the voltage to be applied to power supply terminal 434 is controlled to be 0.5 to 3.0V, the oscillation frequency of ring oscillation circuit 433 can be changed to 450 to 1000 MHz, which are used to receive the UHF band.

In the present embodiment, the oscillation signals of ring oscillation circuit 433 are inputted as balanced inputs to the other inputs 371b to 375b of mixers 371 to 375. It is alternatively possible to use the oscillation signals as unbalanced inputs, without establishing a connection between the other inputs 371b to 375b and input terminals 386 to 390.

## FOURTH EMBODIMENT

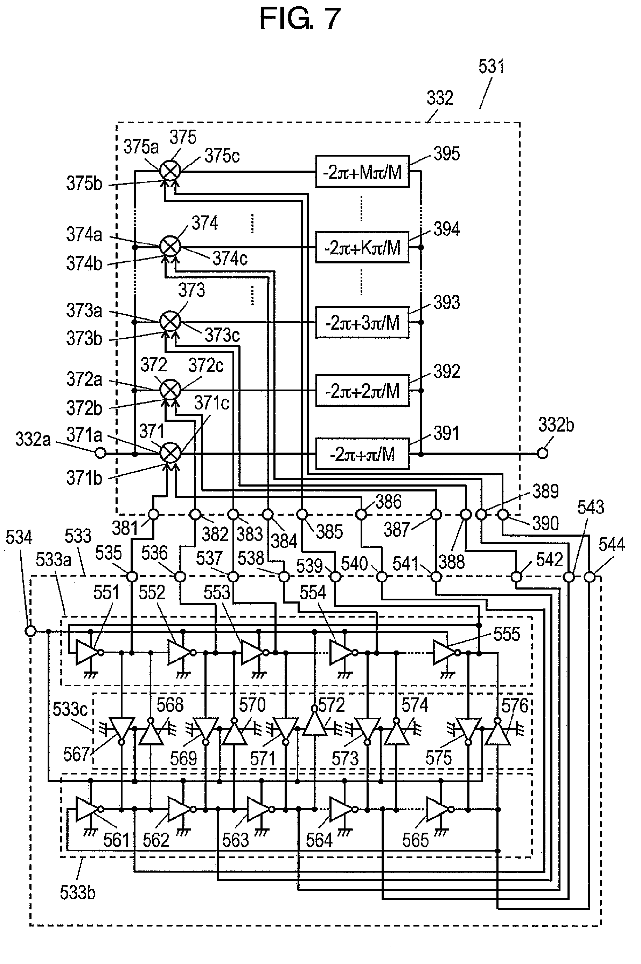

Fig. 7 is a block diagram of mixing device 531 according to a fourth embodiment of the present invention. In the third embodiment, ring oscillation circuit 433 includes first ring oscillating part 433a and second ring oscillating part 433b. In contrast, in the present embodiment, ring oscillation circuit 533 includes third ring oscillating part 533a, fourth ring oscillating part 533b, and oscillation control unit 533c for controlling third and fourth ring oscillating parts 533a and 533b.

The different point of the present embodiment from the third embodiment enables third and fourth ring oscillating part 533a, 533b to be oscillation circuits independent of each other, thereby performing a stable oscillation operation. They can be used, for example, in severe temperature-humidity environments.

In the present embodiment, only five mixers 371 to 375 are shown and the remaining ones of the "M" mixers are omitted in Fig. 7. Similarly, only 20 inverters 551 to 555, 561 to 565, and 567 to 576 are shown and the remaining ones of the (4 × M) inverters are omitted. For convenience of illustration, Fig. 7 shows the case where "M" is 5 or more. The following description is based on the assumption that "K" is 4 or more in accordance with the drawings; however, "K" can be 1 to "M" in the present invention. The present invention is applicable to the case where "M" is 3 or 4 although it differs from the case of Fig. 7. The case is not described any further.

The operation of mixing device 531 is briefly described as follows because it is fundamentally equal to that of mixing device 31 of the first embodiment.

In Fig. 7, mixing device 531 includes mixing circuit 332 and ring oscillation circuit 533 which supplies mixing circuit 332 with an oscillation signal.

The structure of ring oscillation circuit 533 is described as follows. Ring oscillation circuit 533 includes a first ring oscillating part and oscillation control unit 533c. The first ring oscillating part has third and fourth ring oscillating parts 533a and 533b. Oscillation control unit 533c is connected between oscillating parts 533a and 533b so as to control the oscillation operation.

Third ring oscillating part 533a includes "M" inverters 551 to 555 which invert and output input signals and are connected in series in this order in a ring shape.

The output of first inverter 551 is connected to the input of second inverter 552. The output of second inverter 552 is connected to the input of third inverter 553. The output of third inverter 553 is connected to the input of the inverter in the next stage. The output of the (K - 1)th inverter when a serial connection is established between the inverters in the ((k - 1) - 3) stages is connected to the input of K-th inverter 554. The output of K-th inverter 554 is connected to the input of the inverter in the next stage. The output of the (M - 1)th inverter when a serial connection is established between inverters in the ((M - 1) - K) stages is connected to the input of M-th inverter 555. The output of inverter 555 is connected to the input of inverter 551.

In the same manner, fourth ring oscillating part 533b includes "M" inverters 561 to 565 which invert and output input signals. The output of (M + 1)th inverter 561 is connected to the input of (M + 2)th inverter 562. The output of (M + 2)th inverter 562 is connected to the input of (M + 3)th inverter 563. The output of (M + 3)th inverter 563 is connected to the input of the inverter in the next stage. The output of the (M + K - 1)th inverter when a serial connection is established between the inverters in the ((M + K - 1)-(M + 3)) stages is connected to the input of (M + K)th inverter 564. The output of (M + K)th inverter 564 is connected to the input of the inverter in the next stage. The output of the (M + M - 1)th inverter when a serial connection is established between the inverters in the ((M + K - 1)-(M + K) stages is connected to the input of (M + M)th inverter 565. The output of (M + M)th inverter 565 is connected to the input of (M + 1)th inverter 561.

Oscillation control unit 533c includes (2 × M) inverters 567 to 576 which invert and output input signals. Inverter 567, which is the first forward inverter, and inverter 568, which is the first backward inverter, are connected so as to have a positive polarity and a reverse polarity, respectively, in the direction from the output of inverter 551 to the output of inverter 561.

Inverter 569, which is the second forward inverter, and inverter 570, which is the second backward inverter, are connected so as to have a positive polarity and a reverse polarity, respectively, in the direction from the output of inverter 552 to the output of inverter 562.

Inverter 571, which is the third forward inverter, and inverter 572, which is the third backward inverter, are connected so as to have a positive polarity and a reverse polarity, respectively, in the direction from the output of inverter 553 to the output of inverter 563.

Inverter 573, which is the K-th forward inverter, and inverter 574, which is the K-th backward inverter, are connected so as to have a positive polarity and a reverse polarity, respectively, in the direction from the output of inverter 554 to the output of inverter 564.

Inverter 575, which is the M-th forward inverter, and inverter 576, which is the M-th backward inverter, are connected so as to have a positive polarity and a reverse polarity, respectively, in the direction from the output of inverter 555 to the output of inverter 565.

As described above, oscillation control unit 533c includes the K-th forward inverter and the K-th backward inverter between the output of the K-th inverter of third ring oscillating part 533a and the output of the (M + K)th inverter of fourth ring oscillating part 533b so as to control third and fourth ring oscillating parts 533a and 533b.

When "M" is 4, "K" is inevitably 4. Therefore, unlike the structure shown in the drawing, inverters 554 and 555 are identical to each other. Similarly, inverters 564 and 565 are identical to each other; inverters 464 and 465 are identical to each other; inverters 573 and 575 are identical to each other; and inverters 574 and 576 are identical to each other. This case is not described any further here.

The power inputs of inverters 551 to 555, 561 to 565, and 567 to 576 are all connected to power supply terminal 534.

Furthermore, the outputs of inverters 551 to 555 are connected to output terminals 535 to 539, respectively, of ring oscillation circuit 533. The outputs of inverters 561 to 565 are connected to output terminals 540 to 544, respectively, of ring oscillation circuit 533.

These output terminals 535 to 544 are connected as balanced inputs to the other inputs 371b to 375b of mixers 371 to 375.

The operation of ring oscillation circuit 533 thus structured is described as follows. First, the oscillation condition of ring oscillation circuit 533 is described. Ring oscillation circuit 533 oscillates at the frequency at which the degree of amplification of the loop formed by third and fourth ring oscillating parts 533a and 533b is 1 or more and the loop phase delay in third and fourth ring oscillating parts 533a and 533b is $(-2\pi)$ radian.

In third ring oscillating part 533a, the output signal of inverter 551 controls the charging and discharging of mainly the input capacity of inverters 552 and 567.

Consequently, the output signal of inverter 551 is delayed in phase. The output signal of inverter 552 is further delayed in phase. Similarly, the output signals of inverters 553, 554, and 555 are sequentially delayed in phase. Inverters 561 to 565 in fourth ring oscillating part 533b are delayed in phase in the same manner as in third ring oscillating part 533a.

Third and fourth ring oscillating parts 533a and 533b are connected to each other via oscillation control unit 533c. The output of inverter 551 and the output of inverter 561 are connected to each other via inverters 567 and 568. As a result, the output of inverter 561 is delayed by $\pi$ radian from the output of inverter 551. This holds true to between inverters 552 and 562; between inverters 553 and 563; between inverters 554 and 564; and between inverters 555 and 565.

The phases of the outputs of inverters 551 to 555 and 561 to 565 are described as follows.

Inverters 551 to 555 and 561 to 565 are formed of $(2 \times M)$ inverters. Therefore, the phase difference between the input and output of each inverter can be $(-2\pi/2M)$ radian, that is, $(-\pi/M)$ radian, which is obtained by dividing the phase delay between the input signal of inverter 551 and the output signal of inverter 555 by the number of the inverters. In other words, the phase difference of $(-\pi/M)$ radian is obtained by dividing $(-2\pi)$ radian by $(2 \times M)$.

This means that the phase of the output signal is delayed by $(-K\pi/M)$ radian from that of the input signal in each of inverters 551 to 555. As a result, the phases of the output signals of inverters 551 to 555 are delayed from that of the input signal of inverter 551 by $(-\pi/M)$ radian, $(-2\pi/M)$ radian, $(-3\pi/M)$ radian, ... , $(-K\pi/M)$ radian, ..., and $(-2M\pi/M)$ radian, respectively.

These signals are balance-inputted to the other inputs 371b to 375b of mixers 371 to 375 via output terminals 535 to 544, respectively.

The charge currents of inverters 551 to 555 and 561 to 565 can be controlled by the value of the voltage applied to power supply terminal 534 so as to change the oscillation frequency of ring oscillation circuit 533.

In the present embodiment, the oscillation signals of ring oscillation circuit 533 are inputted as balanced inputs to the other inputs 371b to 375b of mixers 371 to 375. It is alternatively possible to use the oscillation signals as unbalanced inputs, without establishing a connection between the other inputs 371b to 375b and input terminals 386 to 390.

## FIFTH EMBODIMENT

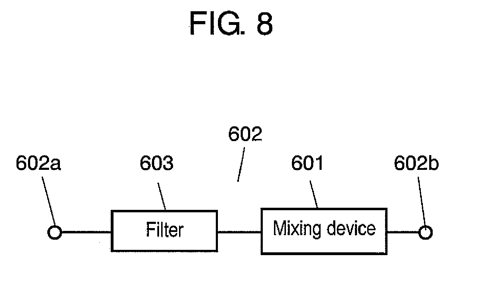

Fig. 8 is a block diagram of radio-frequency receiver 602 according to a fifth embodiment of the present invention. Mixing device 601 used in radio-frequency receiver 602 can be any of the mixing devices used in the first to fourth embodiments of the present invention.

As shown in Fig. 8, in radio-frequency receiver 602 of the present embodiment, the radio frequency signal inputted to input terminal 602a is filtered by filter 603 so as to attenuate signals other than the desired signal, and then inputted to one of mixing devices 31, 331, 431, and 531. The IF signal, which is the output of one of mixing devices 31, 331, 431, and 531, is outputted from output terminal 602b.

In the case of using mixing device 31 including three mixers as mixing device 601, it is possible to suppress the following signals: an image interference signal; interference signals having a frequency higher or lower by the IF than the frequency three times the fundamental frequency of ring oscillation circuit 33; and interference signals having a frequency lower by the IF than the frequency five times the fundamental frequency of ring oscillation circuit 33. Therefore, filter 603 can have lower attenuation characteristics than in the case of using the conventional mixing device for the aforementioned interference signals: the image interference signal; the interference signals having the frequency higher or lower by the IF than the frequency three times the fundamental frequency of ring oscillation circuit 33; and the interference signals having the frequency lower by the IF than the frequency five times the fundamental frequency of ring oscillation circuit 33. This allows mixing device 601 to be small in size and cost.

In the case of using mixing devices 331, 431, or 531 having "M" mixers, on the other hand, it is possible to phase-cancel and suppress an image interference signal and interference signals having a frequency higher or lower by the IF than the frequency three to (2M - 3) times the fundamental frequency of ring oscillation circuit 333. Therefore, filter 603 can have lower attenuation characteristics than in the case of using the conventional mixing device for the following interference signals: the image interference signal; and the interference signals having a frequency higher or lower by the IF than the frequency three to (2M - 3) times the fundamental frequency of ring oscillation circuit 333. This allows mixing device 601 to be small in size and cost.

**INDUSTRIAL APPLICABILITY**

The mixing device of the present invention includes a ring oscillation circuit having inverters connected in multiple stages and a mixing circuit having a plurality of mixers so as to fully suppress various types of interference signals including the image interference signal. The mixing device therefore can be applied to radio-frequency receivers.

**Claims**

1. A mixing device comprising:

    an input terminal for receiving a radio frequency signal;
    a mixing circuit having a first mixer to an M-th mixer connected to each other where "M" is a natural number of not less than 3, the mixing circuit being connected to the input terminal at one input so as to receive the radio frequency signal received by the input terminal;
    a ring oscillation circuit connected to an other input of the mixing circuit so as to supply an output signal thereto;
    an output terminal for receiving an output of the mixing circuit; and
    a K-th phase shifter where "K" is a natural number of 1 to "M", the K-th phase shifter being between the output of a K-th mixer and the output terminal and having a phase shift amount of $(-2\pi + K\pi/M)$ radian, wherein
    the ring oscillation circuit includes a first ring oscillating part having at least a first inverter to a $(2 \times M)$th inverter or at least a first differential amplifier to a $(2 \times M)$th differential amplifier;
    when the ring oscillation circuit includes the first inverter to the $(2 \times M)$th inverter, the other input of the K-th mixer balance-inputs an oscillation signal phase-shifted by $(-K\pi/M)$ radian which outputted from the K-th inverter and an oscillation signal phase-shifted by $(-(M + K)\pi/M)$ radian which outputted from the $(M + K)$th inverter; and
    when the ring oscillation circuit includes the first differential amplifier to the $(2 \times M)$th differential amplifier, the other input of the K-th mixer balance-inputs an oscillation signal phase-shifted by $(-K\pi/M)$ radian which outputted from the K-th differential amplifier and an oscillation signal phase-shifted by $(-(M + K)\pi/M)$ radian which outputted from the $(M + K)$th differential amplifier.

2. The mixing device of claim 1, wherein
    the ring oscillation circuit further includes a second ring oscillating part,
    the ring oscillation circuit includes the first ring oscillating part and the second ring oscillating part;
    the second ring oscillating part includes the first inverter to an L-th inverter where "L" is a natural number of 1 to 2M, a $(L + 2)$th inverter to a $(M + M - 1)$th inverter, and a $(M + M)$th inverter;
    an output of the L-th inverter included in the first ring oscillating part is connected to an output of the L-th inverter included in the second ring oscillating part;
    when "L" is not more than $(M + M - 2)$, the output of the L-th inverter included in the second ring oscillating part is connected to an input of the $(L + 2)$th inverter included in the second ring oscillating part;
    when "L" is equal to $(M + M - 1)$, an output of the $(M + M - 1)$th inverter included in the second ring oscillating part is connected to an input of the first inverter included in the second ring oscillating part; and
    when L is equal to $(M + M)$, an output of the $(M + M)$th inverter included in the second ring oscillating part, the input of the first inverter included in the first ring oscillating part, and an input of the second inverter included in the second ring oscillating part are connected to each other.

3. The mixing device of claim 1, wherein
    the ring oscillation circuit further includes an oscillation control unit,

the first ring oscillating part includes a third ring oscillating part and a fourth ring oscillating part;
the ring oscillation circuit includes the third ring oscillating part, the fourth ring oscillating part, and the oscillation control unit;
the third ring oscillating part includes a first inverter to a K-th inverter and the K-th inverter to an M-th inverter connected in series in a ring shape;
the fourth ring oscillating part includes a (M + 1)th inverter to a (M + K)th inverter and the (M + K)th inverter to the (M + M) th inverter connected in series in a ring shape;
the oscillation control unit includes a K-th forward inverter connected in a forward direction and a K-th backward inverter connected in a backward direction between the output of the K-th inverter included in the third ring oscillating part and the output of the (M + K)th inverter included in the fourth ring oscillating part, in order to control the third ring oscillating part and the fourth ring oscillating part.

4. The mixing device of claim 1, wherein
at least the mixing circuit and the ring oscillation circuit are integrated in a same package.

5. The mixing device of claim 1, wherein
the ring oscillation circuit further includes a power supply terminal and controls a value of a voltage to be applied to the power supply terminal.

6. A radio-frequency receiver comprising:

an input terminal for receiving a radio frequency signal;
a filter for receiving the radio frequency signal received by the input terminal;
the mixing device of claim 1 connected to an output signal of the filter; and
an output terminal for receiving an output signal of the mixing device, wherein
the filter has low attenuation characteristics for an image interference signal; an interference signal having a frequency higher or lower by an IF than a frequency three times a fundamental frequency of the ring oscillation circuit; and an interference signal having a frequency lower by the IF than a frequency five times the fundamental frequency of the ring oscillation circuit.

# FIG. 1

# FIG. 2

| | Input 73a | Input 73b | Output73c | Output76a | Output terminal 32b |
|---|---|---|---|---|---|
| Mixer 73 | 101 / 102 | 123 | 124 / 125 | 126 / 127 | |
| | Input 72a | Input 72b | Output 2c | Output 75a | |
| Mixer 72 | 101 / 102 | 113 | 115 / 114 | 116 / 117 | 128 |
| | Input 71a | Input 71b | Output71c | Output 74a | |
| Mixer 71 | 101 / 102 | 103 | 105 / 104 | 107 / 106 | |

# FIG. 3

| | Input 73a | Input 73b | Output 73c | Output 76a | Output terminal 32b |
|---|---|---|---|---|---|
| Mixer 73 | 201 / 202 | 223 | 224 / 225 | 226 / 227 | |
| | Input 72a | Input 72b | Output 72c | Output 75a | |
| Mixer 72 | 201 / 202 | 213 | 214 / 215 | 216 / 217 | |
| | Input 71a | Input 71b | Output 71c | Output 74a | |
| Mixer 71 | 201 / 202 | 203 | 204 / 205 | 207 / 206 | |

# FIG. 4

# FIG. 5

# FIG. 6

# FIG. 7

# FIG. 8

602

602a    603         601       602b

○——| Filter |——| Mixing device |——○

# FIG. 9

## INTERNATIONAL SEARCH REPORT

| | International application No. |
|---|---|
| | PCT/JP2007/063559 |

| A. CLASSIFICATION OF SUBJECT MATTER |
|---|
| *H03D7/18(2006.01)i, H04B1/26(2006.01)i* |

According to International Patent Classification (IPC) or to both national classification and IPC

| B. FIELDS SEARCHED |
|---|
| Minimum documentation searched (classification system followed by classification symbols) |
| H03D7/18, H04B1/26 |

Documentation searched other than minimum documentation to the extent that such documents are included in the fields searched

| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2004-179841 A (Matsushita Electric Industrial Co., Ltd.), 24 June, 2004 (24.06.04), Full text; all drawings & US 2004/0142673 A1 & EP 1424769 A1 | 1-6 |
| A | JP 2006-510264 A (Koninklijke Philips Electronics N.V.), 23 March, 2006 (23.03.06), Full text; all drawings & US 2006/0063504 A1 & EP 1573897 A & WO 2004/054092 A1 | 1-6 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 16 October, 2007 (16.10.07) | 23 October, 2007 (23.10.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

31

**INTERNATIONAL SEARCH REPORT**

| International application No. |
|---|
| PCT/JP2007/063559 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2002-521904 A  (Global Communication Technology, Inc.),<br>16 July, 2002 (16.07.02),<br>Par. Nos. [0070] to [0082]; Figs. 13B, 14<br>& US 6335952 B1        & US 6194947 B1<br>& WO 2000/005815 A1 | 1-6 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004179841 A

**Non-patent literature cited in the description**

- **AKIHIKO YONEYA.** Papers of Technical Meeting on Electronic Circuits, ECT-03-43, IEE Japan. Nagoya Institute of Technology, 14 March 2003, 1-4